# EUROPÄISCHE PATENTSCHRIFT

(11) **EP 3 712 924 B1**
(45) Veröffentlichungstag und Bekanntmachung des Hinweises auf die Patenterteilung: **16.08.2023**
(21) Anmeldenummer: 20163611.5
(22) Anmeldetag: 17.03.2020
(51) Int. Cl.: H01J 49/44, H01J 37/04, H01J 37/252, H01J 37/05, H01J 49/48

(54) **VORRICHTUNG UND VERFAHREN ZUM ELEKTRONENTRANSFER VON EINER PROBE ZU EINEM ENERGIEANALYSATOR UND ELEKTRONEN-SPEKTROMETERVORRICHTUNG**
DEVICE AND METHOD FOR ELECTRON TRANSFER FROM A SAMPLE TO AN ENERGY ANALYSER AND AN ELECTRON SPECTROMETER DEVICE
DISPOSITIF ET PROCÉDÉ DE TRANSFERT D'ÉLECTRONS D'UN ÉCHANTILLON À UN ANALYSEUR D'ÉNERGIE ET DISPOSITIF SPECTROMÈTRE D'ÉLECTRONS

(30) Priorität: 21.03.2019 DE 102019107327
(43) Veröffentlichungstag der Anmeldung: 23.09.2020
(73) Patentinhaber: SPECS Surface Nano Analysis GmbH, 13355 Berlin (DE)
(72) Erfinder: Schönhense, Gerd, 55276 Oppenheim (DE); Kampen, Thorsten, 13355 Berlin (DE); Schaff, Oliver, 13355 Berlin (DE); Mähl, Sven, 13355 Berlin (DE)
(74) Vertreter: v. Bezold & Partner Patentanwälte - PartG mbB

(56) Entgegenhaltungen:
- EP-A2- 0 246 841
- DE-B4-102013 005 173
- BARRETT N ET AL: "Dark field photoelectron emission microscopy of micron scale few layer graphene", REVIEW OF SCIENTIFIC INSTRUMENTS, AIP, MELVILLE, NY, US, Bd. 83, Nr. 8, 1. August 2012 (2012-08-01) , Seiten 83706-83706, XP012162547, ISSN: 0034-6748, DOI: 10.1063/1.4746279 [gefunden am 2012-08-21]
- ESCHER M ET AL: "Applications of high lateral and energy resolution imaging XPS with a double hemispherical analyser based spectromicroscope", JOURNAL OF ELECTRON SPECTROSCOPY AND RELATED PHENOMENA, ELSEVIER SCIENCE PUBLISHERS, AMSTERDAM, NL, Bd. 178-179, 1. Mai 2010 (2010-05-01), Seiten 303-316, XP027020308, ISSN: 0368-2048 [gefunden am 2009-06-10]

## Beschreibung

Die Erfindung betrifft eine Elektronen-Abbildungsvorrichtung und ein Elektronentransferverfahren zur Übertragung von Elektronen von einer Probe zu einer Energieanalysatorvorrichtung, insbesondere für eine impuls- und energieaufgelöste Detektion der Elektronen, wie z. B Photoelektronen.

Des Weiteren betrifft die Erfindung eine Elektronen-Spektrometervorrichtung, die mit der Elektronen-Abbildungsvorrichtung ausgestattet ist, und ein Elektronen-Spektrometrieverfahren. Anwendungen der Erfindung sind bei der elektronenspektroskopischen Analyse von Proben gegeben.

In der vorliegenden Beschreibung wird auf den folgenden Stand der Technik verwiesen, der den technischen Hintergrund der Erfindung veranschaulicht:
[1] B. Wannberg in "Nucl. Instrum. Meth. A" 601 (2009) 182;
[2] EP 2 823 504 B1;
[3] US 9 997 346 B1;
[4] EP 2 851 933 B1;
[5] SE 539 849 C2;
[6] DE 10 2005 045 622 B4;
[7] DE 10 2013 005 173 B4;
[8] EP 1 559 126 B9;
[9] DE 10 2014 019408 B4; und
[10] M. Patt et al. in "Review of Scientific Instruments" 85, 113704 (2014).

Es ist allgemein bekannt, für die Übertragung und die Fokussierung von Elektronen aus einer Festkörperprobe zu einem Energieanalysator, insbesondere für die Messung von Photoelektronen und Auger-Elektronen, eine Transferoptik mit elektronenoptischen Linsen zu verwenden. Es sind verschiedene Arten von Energieanalysatoren und dazugehörigen Transferoptiken bekannt. Eine Gruppe von Verfahren, bei denen die von der Probe emittierten Elektronen winkelaufgelöst detektiert werden, werden als ARPES-Verfahren (ARPES: angular-resolved photo-electron spectroscopy) bezeichnet (siehe z. B. [1]). Bei den ARPES-Verfahren ist der auf eine Referenzachse, z. B. eine Oberflächennormale der Probenoberfläche, bezogene Emissionswinkel, unter dem Elektronen von der Probe emittiert werden, von besonderem Interesse. In der Vergangenheit wurden zwar hohe Winkelauflösungen erreicht, dies jedoch nur in relativ stark begrenzten Winkelbereichen. Beispielsweise sind bisher eine Hochauflösung von 0,1° in einem Winkelbereich von etwa +/- 7° und eine reduzierte Auflösung von 0,5° in einem Bereich von etwa +/- 15° erreichbar.

Typischerweise werden bei der herkömmlichen Winkelabbildung mit dem ARPES-Verfahren als Energieanalysatoren Halbkugelanalysatoren verwendet, die aus zwei konzentrischen Halbkugel-Elektroden zusammengesetzt sind. In Abhängigkeit von der Spannung zwischen den Halbkugel-Elektroden können nur Teilchen in einem bestimmten Energieband (z. B. Energieintervall mit Breite von 10 % der Passenergie des Halbkugelanalysators) den Halbkugelanalysator passieren. Für eine energie- und winkelaufgelöste Messung erfolgt eine Abbildung der Winkelverteilung der Elektronen auf eine Eintrittsebene des Energieanalysators. In der Eintrittsebene des Energieanalysators wird ein Winkelverteilungsbild von Elektronen aus der Probe im Realraum (in Polarkoordinaten) erzeugt. Indem in der Eintrittsebene eines Halbkugelanalysators eine Spaltblende als Eintrittsspalt angeordnet wird, kann mit dem Halbkugelanalysator die Winkelverteilung entlang einer ersten Winkelkoordinate (z. B. entlang der y-Richtung) entlang der Ausdehnung des Eintrittsspalts erfasst werden. Um auch die Winkelverteilung entlang einer zweiten Koordinate (z. B. x) senkrecht zur ersten Winkelkoordinate zu erfassen, wird durch eine Anordnung von zwei Ablenkern [2] oder einen Ablenker [3] in der Transferlinse das Winkelverteilungsbild einer sequentiellen Abtastung (Scan-Bewegung) senkrecht zur Ausdehnung des Eintrittsspalts und zur elektronenoptischen Achse unterzogen.

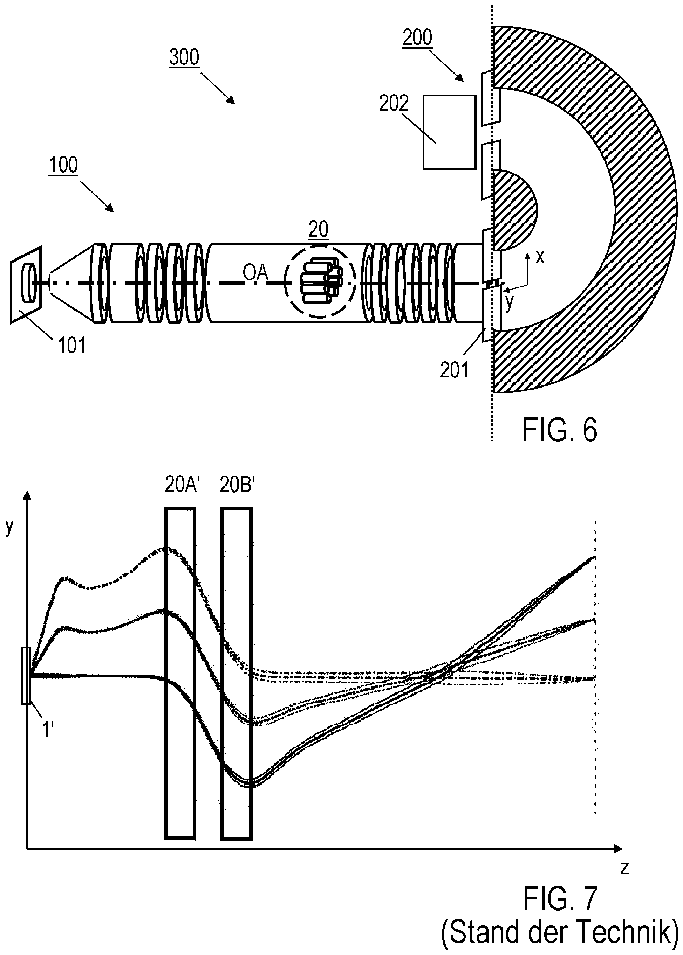

Herkömmliche Transferoptiken zur winkelaufgelösten Messung von Elektronen haben einen erheblichen Nachteil, da bei diesen der Elektronenstrahl am Ausgang der Transferoptik bzw. in der Eintrittsebene des Energieanalysators mit einer starken Divergenz relativ zur elektronenoptischen Achse, z. B. z-Achse, von typischerweise > 10° in den Energieanalysator eintritt. Die Divergenz ist in Figur 7 (Stand der Technik, zitiert aus [2]) am Beispiel des Verlaufs einiger Teilstrahlen von Elektronen aus einer Probe 1' mit verschiedenen Emissionswinkeln in einer y-z-Ebene illustriert (siehe auch [1] und [3]). Sie verursacht Abbildungsfehler im Energieanalysator und erfordert einen hohen Nachbearbeitungsaufwand zur Berechnung von Energie- und Winkelverteilungen der Elektronen. Des Weiteren weisen herkömmliche Transferoptiken kein ausreichend gut fokussiertes und lokalisiertes Ortsbild des Proben-Quellflecks auf, von dem die Elektronen emittiert werden (siehe z. B. [1]).

Die Divergenz wirkt sich insbesondere nachteilig bei der Erfassung der Winkelverteilung entlang der zweiten Winkelkoordinate aus, bei der die zweite Winkelkoordinate mit Hilfe von ein oder zwei Ablenkern 20A', 20B' in der Transferoptik sequenziell abgetastet wird (siehe [1], [2], [3], [4] und [5]). Bei der Scan-Bewegung des divergenten Strahlenbündels senkrecht zur Ausdehnung des Eintrittsspalts entstehen Kombinationsfehler aus der Strahldivergenz in der Eintrittsebene mit Aberrationen, die durch die Auslenkung des Strahls durch die Ablenker induziert werden.

Von Nachteil ist die Strahldivergenz in der Eintrittsebene auch bei der spinaufgelösten Elektronenspektroskopie, bei der ein abbildender Spinfilter mit einem Spinfilterkristall am Ausgang des Energieanalysators angeordnet ist (siehe [6]). Die Strahldivergenz entlang des Eintrittsspaltes in der Eintrittsebene bewirkt eine Strahldivergenz in der Austrittsebene in Form eines starken Astigmatismus, welcher eine gut fokussierte Abbildung des austretenden Strahls auf den Spinfilterkristall unmöglich macht.

Zusammengefasst hat die hohe Winkeldivergenz des Elektronenstrahls am Ende herkömmlicher Transferoptiken erhebliche Nachteile für die winkelaufgelöste Spektroskopie von Elektronen mit Energieanalysatoren, insbesondere mit Halbkugelanalysatoren. Diese Nachteile begrenzen die potentiell nachweisbaren Winkelintervalle und wirken sich verstärkt bei der Nutzung der Scan-Bewegung zur Erfassung der zweiten Winkelkoordinate sowie bei der Nutzung eines abbildenden Spinfilters aus.

In [7], [8], [9] und [10] sind weitere Transferoptiken beschrieben, die für die Impulsmikroskopie vorgesehen sind und teleskopische Strahlengänge enthalten, in denen Gauß-Bilder (Realraumbilder) und Impulsverteilungsbilder (Impulsraumbilder) vorliegen. Diese Transferoptiken sind jedoch nicht für die Scan-Bewegung eines Impulsverteilungsbildes senkrecht zur Ausdehnung eines Eintrittsspalts eines Energieanalysators ausgelegt. Des Weiteren basieren alle diese Techniken auf der Verwendung von Kathodenlinsen, bei denen die Elektronen mittels eines starken elektrostatischen Extraktorfeldes in die Transferoptik beschleunigt werden. Für die Untersuchung von nichtplanaren Oberflächen (wie sie z.B. nach Spalten einer Probe im UHV entstehen können), Mikrostrukturen (wie z.B. Halbleiterbauelemente) oder Mikrokristallen mit dreidimensionaler Struktur (häufige Untersuchungsobjekte von neuen Quantenmaterialien) ist das starke Extraktorfeld jedoch störend.

Die Aufgabe der Erfindung ist es, eine Elektronen-Abbildungsvorrichtung, ein Elektronentransferverfahren, eine Elektronen-Spektrometervorrichtung und/oder ein Elektronen-Spektrometrieverfahren so zu verbessern, dass Nachteile herkömmlicher Techniken vermieden werden. Die Aufgabe ist es insbesondere, Divergenz-bedingte Abbildungsfehler zu minimieren oder sogar auszuschließen, eine verbesserte Winkelauflösung zu erreichen, die Erfassung größerer Winkelintervalle zu erreichen und/oder die spinaufgelöste Elektronenspektroskopie zu vereinfachen.

Diese Aufgaben werden jeweils durch eine Elektronen-Abbildungsvorrichtung, ein Elektronentransferverfahren, eine Elektronen-Spektrometervorrichtung und ein Elektronen-Spektrometrieverfahren mit den Merkmalen der unabhängigen Ansprüche gelöst. Bevorzugte Ausführungsformen und Anwendungen der Erfindung ergeben sich aus den abhängigen Ansprüchen.

Gemäß einem ersten allgemeinen Gesichtspunkt der Erfindung wird die obige Aufgabe durch eine Elektronen-Abbildungsvorrichtung gelöst, die für einen Elektronentransfer entlang einer elektronenoptischen Achse von einer Elektronen emittierenden Probe zu einer Energieanalysatorvorrichtung eingerichtet ist. Der Elektronentransfer umfasst eine Übertragung und Abbildung der emittierten Elektronen (auch als Elektronenbündel oder Elektronenstrahl bezeichnet) von einer Eintrittsebene zu einer Austrittsebene der Elektronen-Abbildungsvorrichtung, wobei die Eintrittsebene an der der Elektronen-Abbildungsvorrichtung zugewandten Oberfläche der Probe und die Austrittsebene an dem hinteren, zur Energieanalysatorvorrichtung weisenden Ende der Elektronen-Abbildungsvorrichtung vorgesehen sind und entsprechend auch als probenseitige und analysatorseitige Eintritts- bzw. Austrittsebene bezeichnet werden. Die elektronenoptischen Achse ist vorzugsweise eine durchgehend gerade Achse, die sich senkrecht zu den Eintritts- und Austrittsebenen erstreckt, kann aber alternativ einen abschnittsweise geraden, gewinkelten Verlauf aufweisen.

Die Elektronen-Abbildungsvorrichtung umfasst eine probenseitige erste Linsengruppe, eine analysatorseitige zweite Linsengruppe und eine Ablenkeinrichtung, die zur elektrischen und/oder magnetischen Ablenkung der Elektronen in der Austrittsebene der Elektronen-Abbildungsvorrichtung in einer Ablenkrichtung senkrecht zur elektronenoptischen Achse eingerichtet ist. Jede der ersten und zweiten Linsengruppe umfasst mindestens zwei elektronenoptische Linsen. Die erste und die zweite Linsengruppe und die Ablenkeinrichtung sind jeweils mit einer Steuerschaltung zur Bereitstellung von Betriebsspannungen verbunden, wobei die Steuerschaltungen getrennte Komponenten oder zu einer gemeinsamen Steuereinrichtung verbunden sein können.

Gemäß der Erfindung ist die erste Linsengruppe zur Bildung einer ersten reziproken Ebene innerhalb der ersten Linsengruppe und einer ersten Gauß-Ebene zwischen der ersten und der zweiten Linsengruppe und zur Erzeugung eines ersten Impulsverteilungsbildes einer Impulsverteilung von Elektronen aus der Probe in der ersten reziproken Ebene und zur Erzeugung eines ersten Gauß-Bildes der Probe, insbesondere des beleuchteten Proben-Quellflecks, in der ersten Gauß-Ebene eingerichtet. Eine reziproke Ebene ist eine Abbildungsebene, in der ein reziprokes Bild (auch Impulsbild oder Fourierbild genannt) vorliegt. Entsprechend ist das erste reziproke Bild, das hier als Impulsverteilungsbild bezeichnet wird, in der ersten reziproken Ebene fokussiert. Das Impulsverteilungsbild ist ein Bild der Impulsverteilung der Elektronen, wobei mit zunehmendem Abstand der Teilstrahlen des Impulsverteilungsbildes von der elektronenoptischen Achse der Transversalimpuls der Elektronen zunimmt. Die Steuerschaltung der ersten Linsengruppe ist zur Beaufschlagung der ersten Linsengruppe mit geeignet passenden Steuerspannungen für die elektronenoptische Bildung der ersten reziproken Ebene und der ersten Gauß-Ebene konfiguriert.

Des Weiteren ist gemäß der Erfindung die zweite Linsengruppe zur Bildung einer zweiten reziproken Ebene analysatorseitig von der zweiten Linsengruppe und zur Erzeugung eines zweiten Impulsverteilungsbildes der Impulsverteilung der Elektronen aus der Probe in der zweiten reziproken Ebene eingerichtet. Die Steuerschaltung der zweiten Linsengruppe ist zur Beaufschlagung der zweiten Linsengruppe mit geeignet passenden Steuerspannungen für die elektronenoptische Bildung der zweiten reziproken Ebene konfiguriert.

Des Weiteren ist gemäß der Erfindung die erste Linsengruppe zur Erzeugung des ersten Gauß-Bildes mit einer derartig geringen Größe (Bildausdehnung senkrecht zur optischen Achse) eingerichtet, dass das mit der zweiten Linsengruppe erzeugte zweite Impulsverteilungsbild ein Parallelbild ist.

Die Ablenkeinrichtung wirkt erfindungsgemäß in einer Gauß-Ebene, z. B. in der ersten Gauß-Ebene oder in einer weiteren Gauß-Ebene (siehe unten), der Elektronen-Abbildungsvorrichtung, so dass durch die Ablenkung der Elektronen vorteilhafterweise eine Parallelverschiebung der Teilstrahlen, welche in der zweiten reziproken Ebene das Parallelbild bilden, ohne eine Veränderung der Winkel zwischen den Teilstrahlen senkrecht zur optischen Achse bewirkt wird.

Der Begriff "Parallelbild" (oder: im Wesentlichen paralleles Winkelbild oder Impulsverteilungsbild mit im Wesentlichen parallelen Teilstrahlen) bezieht sich im Folgenden auf ein Impulsverteilungsbild, dessen Teilstrahlen beim Durchtritt durch die zweite reziproke Ebene parallel zur elektronenoptischen Achse verlaufen und/oder eine derart geringe Divergenz aufweisen, dass Aberrationen (insbesondere Divergenz-bedingte Abbildungsfehler) in der Energieanalysatorvorrichtung für die gewünschte energieaufgelöste Messung der Elektronen vernachlässigbar gering sind, insbesondere keine signifikante Verschlechterung der spektroskopischen Eigenschaften (Energieauflösung, Impulsauflösung) der Energieanalysatorvorrichtung verursachen. Das Parallelbild setzt sich aus Teilstrahlen zusammen, die senkrecht oder nahezu senkrecht relativ zur zweiten reziproken Ebene ausgerichtet sind. Die Teilstrahlen treten als Parallelbündel in die Energieanalysatorvorrichtung ein. Die im Wesentlichen senkrechte Ausrichtung der Teilstrahlen erstreckt sich über einen Winkelbereich der von der Probe emittierten Elektronen, der bei der nachfolgenden Energieanalyse in der Energieanalysatorvorrichtung erfasst werden soll.

Die Steuerschaltung der ersten Linsengruppe ist zur Erzeugung der Steuerspannungen der ersten Linsengruppe so konfiguriert, dass das erste Gauß-Bild die gewünschte Größe aufweist. Die Geometrie der elektronenoptischen Linsen der ersten Linsengruppe ist vorzugsweise so konfiguriert, dass in der ersten Gauß-Ebene ein möglichst kleines Gauß-Bild des Quellflecks der Elektronen auf der Probe entsteht. Die Optimierung der Geometrie der elektronenoptischen Linsen erfolgt z. B. durch numerische Simulationen.

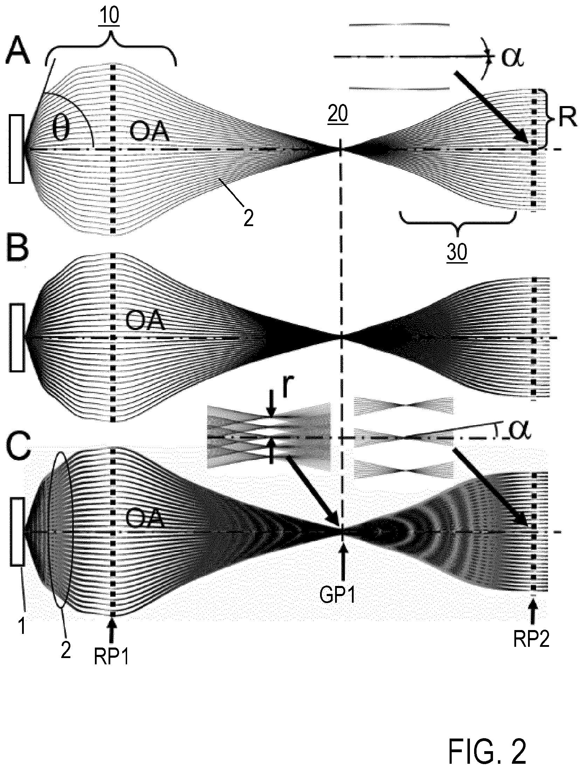

Das Parallelbild (paralleles Impulsverteilungsbild in der Austrittsebene) weist Winkelabweichungen (Divergenzen) seiner Teilstrahlen auf, die kleiner als 0,4°, besonders bevorzugt kleiner als 0,2° sind. Diese Winkelabweichungen haben sich in Simulationen (siehe unten, Figur 2) als ausreichend gering erwiesen, um die nachfolgende Abbildung in der Energieanalysatorvorrichtung nicht zu beeinträchtigen.

Gemäß der Erfindung ist die erste Linsengruppe zur Erzeugung des ersten Gauß-Bildes mit einer Ausdehnung senkrecht zur elektronenoptischen Achse eingerichtet, die geringer als 1 mm, insbesondere geringer als 0,5 mm, ist. Für diese Grö-ßenbereiche wird vorteilhafterweise bei in der Praxis typischerweise auftretenden Messaufgaben und Konfigurationen der Elektronenoptik das parallele Impulsverteilungsbild mit hinreichend kleinen Winkelabweichungen erreicht.

Die Steuerschaltung der Ablenkeinrichtung ist für eine Scan-Ablenkung des Impulsverteilungsbildes in der zweiten reziproken Ebene senkrecht zur elektronenoptischen Achse ausgelegt. Entsprechend werden die Elektronen in der Austrittsebene der Elektronen-Abbildungsvorrichtung einer scannenden Bewegung in einer von der Ausdehnung eines Eintrittsspalts (auch als Spalt oder Spaltblende bezeichnet) der Energieanalysatorvorrichtung abweichenden Richtung, vorzugsweise senkrecht zu dem Eintrittsspalt, unterzogen. Die Konfiguration der ersten und zweiten Linsengruppen und der Ablenkeinrichtung bzw. zugehörigen Steuerschaltungen ist basierend auf Berechnungen mit an sich bekannten elektronenoptischen Abbildungsgleichungen und der geometrischen Größe der Elektronen-Abbildungsvorrichtung eingestellt.

Gemäß einem zweiten allgemeinen Gesichtspunkt der Erfindung wird die obige Aufgabe durch eine Elektronen-Spektrometervorrichtung gelöst, welche eine Probenhalterung zur Halterung einer Probe, die Elektronen-Abbildungsvorrichtung gemäß dem ersten allgemeinen Gesichtspunkt der Erfindung und eine Energieanalysatorvorrichtung umfasst. Gemäß der Erfindung ist die Elektronen-Abbildungsvorrichtung für die Übertragung und Abbildung von Elektronen, die von der Probe emittiert werden, entlang der elektronenoptischen Achse zu der Energieanalysatorvorrichtung und zur Scan-Bewegung des Impulsverteilungsbildes senkrecht zur elektronenoptischen Achse und in einer Ablenkrichtung, die von der Ausdehnung eines Eintrittsspalts der Energieanalysatorvorrichtung abweicht, vorzugsweise in einer Ablenkrichtung senkrecht zur Ausdehnung des Eintrittsspalts angeordnet. Die Elektronen-Abbildungsvorrichtung ist so konfiguriert, dass in der Eintrittsebene der Energieanalysatorvorrichtung ein Impulsverteilungsbild der vom Probenquellfleck emittierten Elektronen als Parallelbild erzeugt wird.

Die Energieanalysatorvorrichtung ist allgemein eine elektronenoptische Abbildungseinrichtung, welche für eine winkel- oder impulsaufgelöste Detektion des Winkel- oder Impulsverteilungsbildes entlang wenigstens einer Richtung senkrecht zur elektronenoptische Achse eingerichtet ist. Die Energieanalysatorvorrichtung umfasst vorzugsweise einen Halbkugelanalysator (hemisphärischer Elektronenenergieanalysator). Durch Verwendung des Halbkugelanalysators mit Eintrittsspalt kann die Winkelverteilung in einer Richtung entlang des Eintrittsspaltes und in einer zweiten, abweichenden Richtung durch die Scan-Bewegung des Impulsverteilungsbildes mittels der Ablenkeinrichtung bestimmt werden. Alternativ zur Verwendung eines Halbkugelanalysators kann die Energieanalysatorvorrichtung andere Analysatortypen, wie z. B. einen Zylinderanalysator oder einen 127°-Analysator umfassen.

Gemäß einem dritten allgemeinen Gesichtspunkt der Erfindung wird die obige Aufgabe durch ein Elektronentransferverfahren gelöst, bei dem mit einer erfindungsgemäßen Elektronen-Abbildungsvorrichtung Elektronen von einer Probe entlang einer elektronenoptischen Achse zu einer Energieanalysatorvorrichtung übertragen werden. Die Probe umfasst vorzugsweise eine Festkörperprobe, deren Oberfläche für eine Bestrahlung mit Anregungslicht und für die Emission hin zur Elektronen-Abbildungsvorrichtung freiliegt. Die aus dem Quellfleck (Auftreff-Fläche des Anregungs-Lichtstrahls) emittierten Elektronen werden aufeinander folgend durch eine probenseitige erste Linsengruppe, eine Ablenkeinrichtung und eine analysatorseitige zweite Linsengruppe übertragen, wobei die Elektronen mit der Ablenkeinrichtung in einer Austrittsebene der Elektronen-Abbildungsvorrichtung in einer Ablenkrichtung, die senkrecht zur elektronenoptischen Achse verläuft und von der Ausdehnung des Eintrittsspalts der Energieanalysatorvorrichtung abweicht, vorzugsweise senkrecht zur Ausdehnung des Eintrittsspalts ausgerichtet ist, abgelenkt werden. Gemäß der Erfindung bildet die erste Linsengruppe eine erste reziproke Ebene innerhalb der ersten Linsengruppe und eine erste Gauß-Ebene zwischen der ersten und der zweiten Linsengruppe, wobei ein erstes Impulsverteilungsbild einer Impulsverteilung von Elektronen aus der Probe in der ersten reziproken Ebene und ein erstes Gauß-Bild des Quellflecks in der ersten Gauß-Ebene erzeugt werden. Des Weiteren bildet die zweite Linsengruppe eine zweite reziproke Ebene analysatorseitig von der zweiten Linsengruppe und ein zweites Impulsverteilungsbild der Impulsverteilung der Elektronen aus der Probe in der zweiten reziproken Ebene. Die erste Linsengruppe erzeugt das erste Gauß-Bild mit einer derart geringen Größe, dass das mit der zweiten Linsengruppe erzeugte zweite Impulsverteilungsbild ein Parallelbild ist.

Gemäß einem vierten allgemeinen Gesichtspunkt der Erfindung wird die obige Aufgabe durch ein Elektronen-Spektrometrieverfahren (Verfahren zur Erfassung der Energie- und Impulsverteilung von Elektronen, die von einer Probe emittiert wurden) gelöst, das eine Bestrahlung einer Probe und Emission von Elektronen von der Probe, eine Übertragung der emittierten Elektronen mit einem Elektronentransferverfahren gemäß dem dritten allgemeinen Gesichtspunkt der Erfindung zu einer Energieanalysatorvorrichtung, und eine impuls- und energieaufgelöste Detektion der Elektronen mit der Energieanalysatorvorrichtung umfasst. Vorzugsweise wird das Elektronen-Spektrometrieverfahren mit der Elektronen-Abbildungsvorrichtung gemäß dem zweiten allgemeinen Gesichtspunkt der Erfindung ausgeführt.

Vorteilhafterweise stellt die vorliegende Erfindung Vorrichtungen und Verfahren für eine substanzielle Verbesserung des Strahltransfers für Elektronen bereit, die von einer Festkörperprobe in vorzugsweise feldfreier Umgebung emittiert und in der Energieanalysatorvorrichtung bezüglich ihrer Energie- und Impulsverteilung analysiert werden. Abbildungsfehler, die bei herkömmlichen Elektronen-Abbildungsvorrichtungen mit der Erzeugung von Winkelbildern im Realraum auftreten, werden durch die Erzeugung eines Impulsverteilungsbildes als Parallelbild vermieden. Indem ein ausreichend kleines Gauß-Bild des auf der Probe durch die Anregungsquelle ausgeleuchteten Bereichs (Proben-Quellfleck) in einer vorderen Fokalebene der zweiten Linsengruppe positioniert wird, so dass in einer hinteren reziproken Ebene dieser Linsengruppe das Impulsverteilungsbild aus parallelen Teilstrahlen entsteht, das in die Ebene des Eintrittsspalts der Energieanalysatorvorrichtung fokussiert wird, treten alle Elektronen im Wesentlichen parallel zur elektronenoptischen Achse in die Energieanalysatorvorrichtung ein. Dadurch werden die Winkelabweichungen am Eintritt der Energieanalysatorvorrichtung im Vergleich mit herkömmlichen Verfahren um 1 bis 2 Größenordnungen reduziert. Das erste Gauß-Bild wird mittels der ersten Linsengruppe erzeugt, die vorzugsweise durch eine geeignete Geometrie aberrationsminimiert ist.

Ein wichtiger Vorteil der Erfindung besteht somit insbesondere in der Möglichkeit, wesentlich größere Winkelbereiche der von der Probe emittierten Elektronen zu erfassen. Da die Beziehung zwischen transversalem Impuls k_{∥} und Bildwinkel α mit der Wurzel aus der Energie skaliert: k_{∥} ~ sin α √ Eₖᵢₙ, sind bei niedrigen kinetischen Energien (z. B. gleich oder kleiner als 5 Elektronenvolt, wie sie z.B. bei Laseranregung vorliegen) Winkelintervalle von mehr als +/-30° möglich, was die Effizienz des Energieanalysators erheblich steigert. Besondere Vorteile der Erfindung ergeben sich auch durch die Abrasterung der zweiten Impulskoordinate zur Erfassung einer zweidimensionalen Impulsverteilung und beim Einsatz eines abbildenden Spinfilters. Durch Positionierung der Ablenkeinrichtung im ersten Gauß-Bild und Brennpunkt der zweiten Linsengruppe lässt sich vorzugsweise mit einer einzigen Ablenkeinheit eine Parallelverschiebung des Impulsverteilungsbildes in der Eintrittsebene der Energieanalysatorvorrichtung erreichen, wobei die Parallelität des Strahlenbündels erhalten bleibt.

Vorteilhafterweise können die Aberrationen der Kombination von Linsengruppen und Ablenkeinrichtung auf das theoretisch mögliche Mindestmaß reduziert werden, indem das zum gewünschten Impulsverteilungsbild reziproke Bild (d.h. das erste Gauß-Bild des Quellflecks auf der Probe) so klein ist, dass die Kodierung des Impulsverteilungsbildes als Flugrichtung in diesem kleinen Gauß-Bild mit sehr hoher Präzision definiert ist. In dieser Eigenschaft unterscheidet sich die vorliegende Erfindung von allen herkömmlichen Strahltransfersystemen, insbesondere gemäß [1, 2, 3, 4] und [5].

Die Erfinder haben festgestellt, dass mit der erfindungsgemäßen Technik ein in der Elektronenmikroskopie realisiertes Konzept, insbesondere die Schaffung von vorbestimmten, sehr gut fokussierten Realraum-Bildern und reziproken Bildern in vorbestimmten Abbildungsebenen unter Ausnutzung des optischen Bildwechselsatzes zusätzlich zu der Verringerung der Aberrationen im elektronenoptischen System bei der Elektronenspektroskopie einen wesentlichen weiteren Vorteil bietet: Indem das erste Gauß-Bild mittels der ersten Linsengruppe entlang der elektronenoptischen Achse verschiebbar ist, können die Kippwinkel der einzelnen Teilstrahlen des Impulsverteilungsbildes in der Eintrittsebene der Energieanalysatorvorrichtung minimiert werden, ohne dass die Strahlposition verloren geht. Dadurch lässt sich das Ablenkverfahren zur Abrasterung der zweiten, insbesondere zum Eintrittsspalt senkrechten, Impulsrichtung auch für hohe Retardierungsverhältnisse (Verhältnis der anfänglichen kinetischen Energie der Elektronen beim Austritt aus der Probe zur kinetischen Energie beim Eintritt in die Energieanalysatorvorrichtung) anwenden. Die bevorzugte Ausführung der zweiten Linsengruppe in Form einer Zoomlinse (Linse, die für eine Einstellung einer Bildvergrößerung eingerichtet ist und vorzugsweise fünf oder mehr Linsenelemente umfasst) erlaubt es insbesondere, die Bildgröße und Elektronenenergie des Impulsbildes am Ausgang der Elektronen-Abbildungsvorrichtung in weiten Grenzen zu verändern und so Impulsbildgröße und Energie an die gewünschten Bedingungen für den Energieanalysator (Energieauflösung, Impulsauflösung) anzupassen.

Vorteilhafterweise wird durch die Schaffung des Parallelbildes in der Eintrittsebene der Energieanalysatorvorrichtung auch eine spinaufgelöste Elektronenspektroskopie vereinfacht, da Bildfehler an einem Spinfilterkristall am Ausgang des Energieanalysators reduziert oder komplett vermieden werden.

Ein weiterer, besonders wichtiger Vorteil der Erfindung besteht darin, dass die Ablenkung des Impulsverteilungsbildes vereinfacht wird. So ist gemäß einer bevorzugten Ausführungsform der Erfindung vorgesehen, dass die Ablenkeinrichtung ausschließlich in einer einzigen, relativ zur elektronenoptischen Achse senkrechten Ebene wirksam ist. Die Ablenkeinrichtung wirkt bei der Übertragung der Elektronen entlang der elektronenoptische Achse ein einziges Mal, wenn die Elektronen den Raum zwischen der ersten Linsengruppe und der zweiten Linsengruppe durchlaufen. Vorteilhafterweise werden damit herkömmliche, komplexe Doppelablenker z. B. gemäß [2] vermieden, ohne dass Abbildungsfehler in Kauf genommen werden müssen. Besonders bevorzugt fallen die Ablenkebene der Ablenkeinrichtung und die erste Gauß-Ebene (oder eine weitere Gauß-Ebene, siehe unten) zusammen, so dass vorteilhafterweise eine exakte Parallelverschiebung des Impulsverteilungsbildes in der zweiten reziproken Ebene durch Betätigung der Ablenkeinrichtung ermöglicht wird. Dabei wird eine zusätzliche Strahlverkippung, wie sie z.B. in [3] und [5] beschrieben ist, vollständig vermieden.

Die Ablenkung in einer einzigen Ebene hat den weiteren Vorteil, dass die Ablenkeinrichtung besonders einfach, z. B. mit einem einzigen Paar von elektrisch und/oder magnetisch wirksamen Ablenkelementen, einer Quadrupolanordnung oder einer Oktupolanordnung von Ablenkelementen aufgebaut sein kann. Im Falle einer elektrischen Ablenkung umfassen die Ablenkelemente Ablenkelektroden, und bei einer magnetischen Ablenkung umfassen die Ablenkelemente Ablenkspulen. Die Oktupolanordnung ermöglicht vorteilhafterweise eine Drehung der Ablenkrichtung um die elektronenoptische Achse, so dass die Ablenkeinrichtung zusätzlich die Richtung der Verschiebung des Impulsverteilungsbildes relativ zur Ausrichtung des Eintrittsspalts der Energieanalysatorvorrichtung drehen kann und so z.B. ungewünschte Bilddrehungen durch magnetische Streufelder ausgleichen kann.

Gemäß einer weiteren vorteilhaften Ausführungsform der Elektronen-Abbildungsvorrichtung (im Folgenden auch als erste Ausführungsform bezeichnet) ist deren zweite reziproke Ebene zugleich die Austrittsebene der Elektronen-Abbildungsvorrichtung, wobei in der zweiten reziproken Ebene eine Spaltblende angeordnet ist, die den Eintrittsspalt der Energieanalysatorvorrichtung bildet. Diese Ausführungsform bietet die Vorteile einer Einstellung des Parallelbildes unmittelbar bei Eintritt in die Energieanalysatorvorrichtung und einer relativ kompakten Bauform.

Gemäß alternativen Ausführungsformen der Elektronen-Abbildungsvorrichtung weist diese mindestens eine dritte Linsengruppe auf, die analysatorseitig von der zweiten Linsengruppe, d. h. im Gesamtaufbau der Elektronen-Spektrometervorrichtung zwischen der zweiten Linsengruppe und der Energieanalysatorvorrichtung angeordnet ist. Die mindestens eine dritte Linsengruppe bildet die zweite Gauß-Ebene innerhalb der mindestens einen dritten Linsengruppe und analysatorseitig von der mindestens einen dritten Linsengruppe eine dritte reziproke Ebene, so dass mit der mindestens einen dritten Linsengruppe ein zweites Gauß-Bild der Probe in der zweiten Gauß-Ebene und ein drittes Impulsverteilungsbild der Impulsverteilung der Elektronen aus der Probe in der dritten reziproken Ebene gebildet wird. Die dritte reziproke Ebene ist die Austrittsebene der Elektronen-Abbildungsvorrichtung und die Eintrittsebene der Energieanalysator-Vorrichtung, und das mit der mindestens einen dritten Linsengruppe erzeugte dritte Impulsverteilungsbild ist ein Parallelbild. Auch im Fall dieser alternativen Ausführungsformen der Erfindung ist die Scan-Bewegung des Impulsverteilungsbildes vorgesehen, die eine entsprechende Ablenkung des Impulsverteilungsbildes in der dritten reziproken Ebene bewirkt. Die mindestens eine dritte Linsengruppe ist mit einer Steuerschaltung ausgestattet, die zur Beaufschlagung der mindestens einen dritte Linsengruppe mit geeignet passenden Steuerspannungen für die elektronenoptische Bildung der dritten reziproken Ebene und der zweiten Gauß-Ebene konfiguriert ist. Die Bereitstellung der mindestens einen dritten Linsengruppe hat den besonderen Vorteil, dass die Strahlenergie im parallelen Impulsverteilungsbild in der Eintrittsebene der Energieanalysatorvorrichtung in einem Bereich von z. B. zwei Größenordnungen variiert werden kann und so das Optimum von Auflösung und Transmission der Energieanalysatorvorrichtung eingestellt werden kann.

Zur Bildung des Eintrittsspalts der Energieanalysatorvorrichtung kann eine Spaltblende in der zweiten reziproken Ebene vor der dritten Linsengruppe angeordnet sein (im Folgenden auch als zweite Ausführungsform bezeichnet). In diesem Fall ist die Spaltblende nicht direkt in der Eintrittsebene der Energieanalysatorvorrichtung, sondern in der zur Eintrittsebene konjugierten, zweiten reziproken Ebene vor der dritten Linsengruppe positioniert, wo das parallele Impulsverteilungsbild erzeugt wird, so dass in der Eintrittsebene des Analysators ein reelles Bild der Spaltblende, überlagert mit dem parallelen Impulsverteilungsbild, erzeugt wird. Vorteilhafterweise können in dieser Anordnung die Elektronen mit einer wesentlich größeren Energie den Eintrittsspalt passieren, was die nachfolgende Abbildung in der Energieanalysatorvorrichtung verbessert. Indem die Spaltblende in der zweiten reziproken Ebene angeordnet wird, kann die Spaltblende als reelles Bild in die Eintrittsebene der Energieanalysatorvorrichtung abgebildet werden, um damit effektive Spaltbreite und Energie der Elektronen in der Eintrittsebene bei fester physischer Spaltbreite elektronenoptisch zu variieren.

Alternativ kann die Spaltblende, die den Eintrittsspalt der Energieanalysatorvorrichtung bildet, in der dritten reziproken Ebene angeordnet sein, und sie bildet den Eintrittsspalt der Energieanalysatorvorrichtung, wobei in diesem Fall in der zweiten reziproken Ebene keine Spaltblende angeordnet ist (im Folgenden auch als dritte Ausführungsform bezeichnet). Die dritte Ausführungsform bietet insbesondere den Vorteil, dass ein Energieanalysator in konventioneller Gestaltung, d.h. mit integriertem Eintrittsspalt, verwendet werden kann.

Gemäß weiteren abgewandelten Ausführungsformen der Erfindung können eine vierte Linsengruppe oder weitere Linsengruppen vorgesehen sein, die jeweils wie die dritte Linsengruppe aufgebaut sind und weitere Gauß-Ebenen und reziproke Ebenen bereitstellen.

Vorteilhafterweise bestehen verschiedene Möglichkeiten, die Ablenkeinrichtung zu positionieren. Insbesondere bei der ersten, zweiten und dritten Ausführungsform der Erfindung kann die Ablenkeinrichtung zwischen der ersten und der zweiten Linsengruppe und in der ersten Gauß-Ebene angeordnet sein. Alternativ kann die Ablenkeinrichtung bei der zweiten und dritten Ausführungsform der Erfindung an der dritten Linsengruppe und in der zweiten Gauß-Ebene angeordnet sein. Gemäß weiteren Alternativen kann die Ablenkeinrichtung in einer weiteren Gauß-Ebene in der vierten Linsengruppe oder einer weiteren Linsengruppe angeordnet sein.

Ein weiterer wichtiger Unterschied gegenüber elektronenoptischen Konzepten der Elektronen-Impulsmikroskopie wird gemäß einer vorteilhaften Ausführungsform der Erfindung erzielt, bei der das probenseitig vorderste elektronenoptische Linsenelement der ersten Linsengruppe eingerichtet ist, das gleiche Potential wie die Probe aufzuweisen. Vorteilhafterweise wird dadurch der Bereich um die Probe feldfrei gehalten, so dass auch stark dreidimensional strukturierte Proben oder Mikrokristalle untersucht werden können, ohne dass eine signifikante Feldverzerrung durch die dreidimensionale Form auftritt, welche die Impulsauflösung verschlechtern würde.

Für die Verschiebung des Impulsverteilungsbildes in der zweiten reziproken Ebene ist besonders bevorzugt vorgesehen, dass die Ablenkeinrichtung in der ersten Gauß-Ebene wirksam ist. Die Anordnung in der ersten Gauß-Ebene bedeutet, dass die Ablenkeinrichtung variierende Ablenkfelder erzeugt, welche in einem engen Bereich symmetrisch um die erste Gauß-Ebene wirken. Diese Ausführungsform hat die Vorteile einer besonders effektiven Ablenkung des gesamten Elektronenstrahls, wobei die Parallelität des Impulsbildes am Ausgang der Abbildungsvorrichtung erhalten bleibt. Alternativ kann bei Bereitstellung der dritten Linsengruppe die einzelne Ablenkeinrichtung in der zweiten Gauß-Ebene angeordnet sein und auf die Elektronen im zweiten Gauß-Bild wirken, wobei ebenfalls die Parallelität des Impulsbildes am Ausgang der Abbildungsvorrichtung bei der Ablenkung erhalten bleibt.

Gemäß einer weiteren vorteilhaften Ausführungsform der Erfindung ist vorgesehen, dass die analysatorseitig hinterste elektronenoptische Linse der zweiten Linsengruppe im Bereich der zweiten reziproken Ebene einen feldfreien Raum bildet. Alternativ oder zusätzlich ist bei der zweiten oder dritten Ausführungsform vorgesehen, dass die dritte Linsengruppe an ihren Enden Randelemente aufweist, die eingerichtet sind, beidseitig an die dritte Linsengruppe angrenzend feldfreie Räume zu bilden. Durch diese Ausführungsform wird vermieden, dass ein elektrostatischer Durchgriff von Feldern zu einer Ablenkung der Elektronenbahnen und damit zu einer Verzerrung des Impulsbildes führt.

Weitere Einzelheiten und Vorteile der Erfindung werden im Folgenden unter Bezug auf die beigefügten Zeichnungen beschrieben. Diese zeigen in
- Figur 1:: schematische Illustrationen der ersten Ausführungsform der Elektronen-Abbildungsvorrichtung gemäß der Erfindung;
- Figur 2:: weitere Illustrationen der Erzeugung eines Gauß-Bildes bei Anregung einer Probe mit verschiedenen Anregungsquellen;
- Figur 3:: eine schematische Illustration der zweiten Ausführungsform der erfindungsgemäßen Elektronen-Abbildungsvorrichtung;
- Figur 4:: eine schematische Illustration der dritten Ausführungsform der erfindungsgemäßen Elektronen-Abbildungsvorrichtung;
- Figur 5:: schematische Illustrationen verschiedener Varianten einer Ablenkeinrichtung;
- Figur 6:: eine schematische Illustration einer Ausführungsform der erfindungsgemäßen Elektronen-Spektrometervorrichtung; und
- Figur 7:: eine Darstellung von Strahlverläufen einer herkömmlichen Transferoptik (zitiert aus [2]).

Die Erfindung wird im Folgenden unter beispielhaftem Bezug auf eine Elektronen-Abbildungsvorrichtung in Kombination mit einem Halbkugelanalysator beschrieben. Die Erfindung ist auf die Verwendung des Halbkugelanalysators nicht beschränkt, sondern vielmehr auch mit anderen Typen von Energieanalysatorvorrichtungen realisierbar. Einzelheiten der Anregung einer Probe und der Aufnahme von Energieverteilungen der von einer Probe emittierten Elektronen mit dem Halbkugelanalysator werden nicht beschrieben, da diese an sich von herkömmlichen Techniken bekannt sind. Die Illustrationen der elektronenoptischen Komponenten in den Zeichnungen sind schematische Darstellungen. Einzelheiten, wie z. B. die Anordnung der elektronenoptischen Komponenten in einem evakuierten Raum oder die Bildung elektronenoptischer Linsen aus beabstandeten Linsenelementen, sind nicht dargestellt. Generell können z. B. elektronenoptische Linsen und die zugehörigen Steuerschaltungen realisiert werden, wie es an sich von herkömmlichen Transferoptiken bekannt ist.

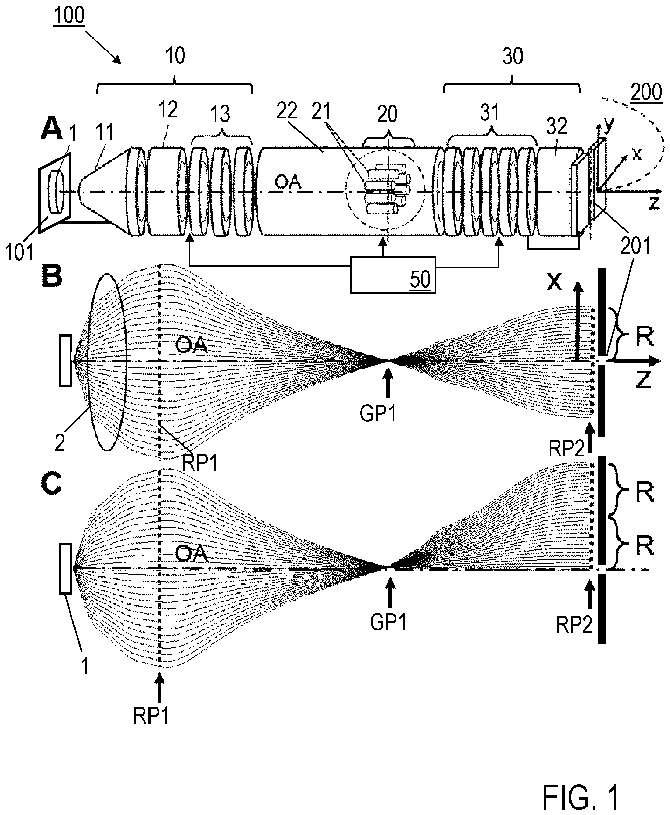

Die Figuren werden unter Bezug auf die in Figur 1 gezeigten relevanten Raumrichtungen beschrieben, die im Ortsraum die z-Richtung entlang der elektronenoptischen Achse und dazu senkrecht die x- und y-Richtungen umfassen, wobei sich eine Spaltblende 201 in der Eintrittsebene der Energieanalysatorvorrichtung 200 (siehe auch Figur 6) in y-Richtung erstreckt. Entsprechend definiert die Richtung der Spaltblende die Richtung der Impulskoordinate k_{y} und dazu senkrecht die Impulskoordinate kₓ.

Figur 1 zeigt die erste Ausführungsform der erfindungsgemäßen Elektronen-Abbildungsvorrichtung 100 in Gestalt eines elektronenoptischen Systems zur Übertragung und transversalen Verschiebung eines parallelen Impulsverteilungsbildes auf Basis einer elektronenoptischen Säule mit mehreren Linsengruppen 10, 30 und einer feldfreien Driftstrecke 22, in der eine Ablenkeinrichtung 20 angeordnet ist. Figur 1A zeigt den Aufbau der Elektronen-Abbildungsvorrichtung 100, Figur 1B zeigt den simulierten Strahlengang für eine realistische Optik bei ausgeschalteter Ablenkeinrichtung 20, und Figur 1C zeigt den simulierten Strahlengang für identische Linseneinstellungen wie in Figur 1B, jedoch mit eingeschalteter Ablenkeinrichtung 20 durch Anlegen von geeigneten Spannungen an die Ablenkelektroden 21. Die radiale Koordinate ist in Figur 1B,C und auch in allen Abbildungen von Elektronenbahnen in den Figuren 2, 3 und 4 radial gestreckt um die Details der einzelnen Strahlenbündel deutlicher sichtbar zu machen. Die Linsengruppen 10, 30 und die Ablenkeinrichtung 20 sind mit einer Steuereinrichtung 50 verbunden, die Steuerschaltungen zur Beaufschlagung der elektronenoptischen Linsen oder Elektroden der Komponenten 10, 20 und 30 umfasst. Die Elektronen-Abbildungsvorrichtung 100 ist mit einem Abstand von z. B. 15 mm zwischen der Oberfläche einer Probe 1 und einer Frontkappen-Elektrode 11 der ersten Linsengruppe 10 auf einer Probenhalterung 101 angeordnet, so dass sich die Probe 1 in der Gegenstandsebene der ersten Linsengruppe 10 befindet. Die Länge der Spaltblende 201 beträgt z. B. 20 mm bis 40 mm, und seine Breite beträgt z. B. 50 µm bis 2 mm.

Im Einzelnen umfasst die erste Linsengruppe 10 gemäß Figur 1A eine Frontkappen-Elektrode 11, eine Fokuselektrode 12 und Anpassungslinsen 13. Zur Bildung eines feldfreien Raumes zwischen der Probe 1 und der ersten Linsengruppe 10 kann die Probenhalterung 101 elektrisch mit der Frontkappen-Elektrode 11 verbunden sein, so dass sich beide Komponenten auf dem gleichen elektrischen Potential befinden. Die zweite Linsengruppe 30 umfasst mehrere Linsenelemente 31, die vorzugsweise eine Zoomlinse bilden, und ein Randelement 32 zur Bildung eines feldfreien Raumes zwischen dem hintersten Linsenelement und der Spaltblende 201 der Energieanalysatorvorrichtung 200. Hierzu sind das Randelement 32 und die Spaltblende 201 elektrisch miteinander verbunden.

Zur Bildung der feldfreien Driftstrecke 22 zwischen der erste Linsengruppe 10 und der zweiten Linsengruppe 30 ist ein z. B. zylinderförmiges Element mit einer derartigen Länge vorgesehen, dass ein Durchgriff der angrenzenden Linsengruppen reduziert wird und am Ort der Ablenkeinrichtung im ausgeschaltetem Zustand kein signifikantes elektrisches Feld mehr vorliegt, welches im Bereich des Gauß-Bildes die Elektronenbahnen ablenken könnte.

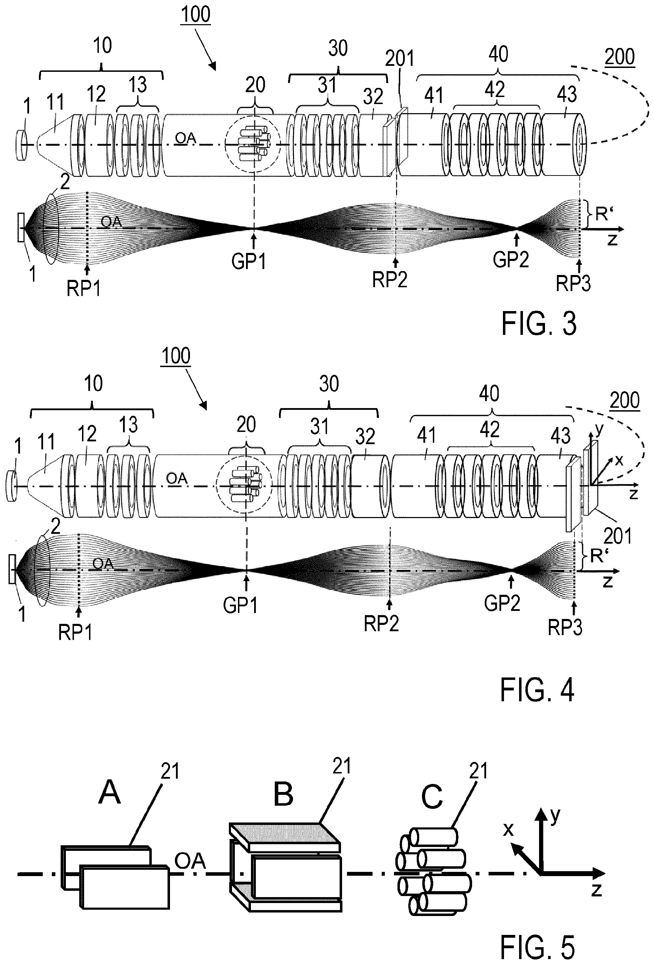

Die Ablenkeinrichtung 20 umfasst z. B. eine Oktupolanordnung von Ablenkelektroden 21 oder alternativ eine andere Elektrodenanordnung (siehe Figur 5). Vorzugsweise ist die Ablenkeinrichtung 20 ein Einfachablenker, d. h. die Elektronen werden bei der Bewegung entlang der elektronenoptische Achse OA zwischen der Probe und der zweiten reziproken Ebene bei Durchtritt durch die der erste Gauß-Ebene ein einziges Mal abgelenkt.

Bei Anregung der Probe 1 mit Licht (siehe auch Figur 2) wird ein Ensemble von Elektronen 2 von der Probe emittiert (Figur 1B), wobei mit der ersten Linsengruppe 10 die Elektronen 2 bis zu einem vorbestimmten Emissionswinkel von z. B. +/- 15° entlang der elektronenoptischen Achse OA abgebildet werden. Gemäß Figur 1B, welche die Elektronen-Abbildungsvorrichtung 100 in der x-z-Ebene mit der Spaltblende 201 der Energieanalysatorvorrichtung 200 senkrecht zur Zeichenebene zeigt, erzeugt die erste Linsengruppe 10 in der ersten reziproken Ebene RP1 ein reziprokes Bild von dem Elektronen 2 emittierenden Proben-Quellfleck und in der ersten Gauß-Ebene GP1, die eine hintere Bildebene der ersten Linsengruppe 10 ist, ein erstes Gauß-Bild des Proben-Quellflecks. Mit der zweiten Linsengruppe 30 wird ein zweites reziprokes Bild (Impulsverteilungsbild mit parallelen Teilstrahlen) in den Eintrittsspalt der Energieanalysatorvorrichtung 200 abgebildet. Auf diese Weise wird gewährleistet, dass alle Elektronen als parallele Teilstrahlen mit sehr geringen Winkelabweichungen in die Energieanalysatorvorrichtung 200 eintreten. Die erste Linsengruppe 10 wird so angesteuert, dass der Schnittpunkt der ersten Gauß-Ebene GP1 mit der elektronenoptischen Achse OA in der Ablenkebene der Ablenkeinrichtung 20, insbesondere im Zentrum der Ablenkeinrichtung 20, positioniert ist. Die Zentrierung des Gauß-Bildes auf die Ablenkeinrichtung 20 ermöglicht eine exakte Parallelverschiebung des durch die zweite Linsengruppe 30 in der zweiten reziproken Ebene RP2 erzeugten Impulsverteilungsbildes mit parallelen Teilstrahlen. Durch Anlegen von geeigneten Spannungen an die Ablenkeinrichtung 20 kann das Impulsverteilungsbild in der zweiten reziproken Ebene RP2 parallel verschoben werden, ohne dass eine zusätzliche Strahlkippung auftritt, wie in Figur 1C gezeigt ist.

Figur 1C zeigt die Wirkung der in der ersten Gauß-Ebene GP1 wirkenden Ablenkeinrichtung 20 für eine optimierte Linsengeometrie und praktische Messbedingungen (+/-15° Winkelintervall, kinetische Energie auf der Probe 16 eV, was zu einer gebräuchlichen Vakuum-Ultraviolett-Laborlichtquelle passt). Bei der durch die Spannungen an den Ablenkelektroden 21 eingestellten Stärke der Ablenkeinrichtung 20 wird im gezeigten Beispiel das analysatorseitige Impulsverteilungsbild in der zweiten reziproken Ebene RP2 um einen Impulsbildradius R parallelverschoben. Durchmesser 2R und Parallelität des Impulsverteilungsbildes bleiben bei der Parallelverschiebung erhalten. Durch kontinuierliche Variation der Ablenkstärke der Ablenkeinrichtung 20 mittels einer Steuerschaltung (Steuereinrichtung 50) lässt sich somit das zweidimensionale Impulsbild vollständig abrastern.

Figur 2 zeigt den Strahlenverlauf der Elektronen 2 analog zu Figur 1B mit verschiedenen Anregungsquellen (nicht gezeigt) zur Erzeugung der Elektronen 2, wobei gemäß Figur 2A eine Anregung mit dem Lichtstrahl einer Synchrotronstrahlungsquelle oder eines Lasers, gemäß Figur 2B eine Anregung mit einer fokussierten Vakuum-UV Anregungsquelle und gemäß Figur 2C eine Anregung mit einer unfokussierten Vakuum-UV Anregungsquelle gezeigt sind.

Der Winkel θ bezeichnet den Emissionswinkel der Elektronen von der Probe bezüglich der elektronenoptische Achse OA und der Winkel α den (halben) Öffnungswinkel eines zu einem bestimmten Emissionswinkel korrespondierenden Strahlenbündels des Impulsverteilungsbildes in der zweiten reziproken Ebene RP2. Der Betrag dieses Öffnungswinkels α der Teilstrahlen (nahezu unsichtbar im Detail in Figur 2A, jedoch deutlich sichtbar im Detail in Figur 2C) ist durch die Größe des Quellbereichs der Elektronen auf der Probenoberfläche und damit durch den Querschnitt des anregenden Lichtstrahls und seinen Einfallswinkel auf die Probe bestimmt.

Für eine praktische Ausführungsform der erfindungsgemäßen Elektronen-Abbildungsvorrichtung 100 wurden mit einem Trajektorien-Simulationsprogramm (SIMION 8.0) wirklichkeitsgetreue Rechnungen durchgeführt, von denen drei exemplarisch in Figur 2 wiedergegeben sind. Der Abstand entlang der Axialkoordinate z zwischen der Oberfläche der Probe 1 und dem Impulsverteilungsbild in der zweiten reziproken Ebene RP2 ist 462 mm. Die elektronenoptischen Linsen sind aberrations-minimiert, und es wurde hier eine verkleinerte Abbildung des Quellbereichs auf der Probe in die Gauß-Ebene GP1 mit einem Vergrößerungsfaktor M = 0,6 eingestellt. Andere Vergrößerungen, auch solche mit M > 1, sind erfindungsgemäß ebenfalls möglich.

Die Simulationen für einen Winkelakzeptanzbereich von θ = 15° liefern die folgenden Parameter: In allen drei Fällen hat das Impulsverteilungsbild in der zweiten reziproken Ebene RP2 einen Radius R von 4,3 mm. Die Verkippungen der Mittelstrahlen der Bündel (=Abweichung vom Parallelstrahl) sind sämtlich < 0,09° und hängen erwartungsgemäß nicht von der Größe des Quellbereichs ab.

Bei der Anregung mit Synchrotronstrahlung oder Laserquellen (Figur 2A) wurde als typische Größe des Lichtstrahls auf der Probe 50 µm angenommen. Das erste Gauß-Bild in der ersten Gauß-Ebene GP1 ist aufgrund des großen Winkelbereichs von θ = 15° durch die sphärische Aberration der ersten Linsengruppe 10 verbreitert und hat einen Radius von r ~ 40 µm. Die Teilstrahlen in Ebene RP2 haben einen Öffnungswinkel von α ≤ 0,16°. Dieser Wert ist nahezu zwei Größenordnungen kleiner als die entsprechenden Werte der Winkeldivergenz in den bisherigen Transferlinsensystemen, wie z.B. in Figur 7 dargestellt ist.

Fokussierte Vakuum-UV Lichtquellen (Figur 2B) haben typische Lichtfleckgrößen von 200 µm. Das erste Gauß-Bild in der ersten Gauß-Ebene GP1 hat in diesem Fall einen Radius von 80 µm, und der Öffnungswinkel der Strahlenbündel, d.h. die resultierende Winkeldivergenz im Impulsbild in Ebene RP2 ist α ≤ 0,2°.

Für unfokussierte Vakuum-UV Laborquellen (Figur 2C) hat ein Anregungs-Lichtstrahl einen typischen Durchmesser von z. B. 0,5 mm, was in der ersten Gauß-Ebene GP1 zu einem ersten Gauß-Bild mit Radius r = 155 µm führt. Der Öffnungswinkel der Strahlenbündel in der Ebene RP2 beträgt hier α ~ 0,35°. Das Detail in Figur 2C ist radial sehr stark gestreckt, um den kleinen Winkel zu verdeutlichen. Das Impulsverteilungsbild in der zweiten reziproken Ebene RP2 ist auch in diesem Fall scharf fokussiert, und die Elektronen treten als Parallelbündel mit geringer Divergenz in die Energieanalysatorvorrichtung 200 ein.

Figur 3 zeigt eine bevorzugte Variante der zweiten Ausführungsform der erfindungsgemäßen Elektronen-Abbildungsvorrichtung 100, wobei analog zu Figur 1 die Komponenten 10, 20 und 30 und ihre Teile vorgesehen sind. Im Unterschied zur ersten Ausführungsform ist zusätzlich eine dritte Linsengruppe 40 vorgesehen, die analysatorseitig hinter der Spaltblende 201 ein zweites Gauß-Bild in der zweiten Gauß-Ebene GP2 und ein drittes Impulsverteilungsbild mit parallelen Teilstrahlen in einer dritten reziproken Ebene RP3 erzeugt. Die dritte reziproke Ebene RP3 ist die Eintrittsebene der Energieanalysatorvorrichtung 200, so dass die Elektronen 2 als Parallelbündel in die Energieanalysatorvorrichtung 200 eintreten. Die dritte Linsengruppe 40 umfasst elektronenoptische Linsenelemente 42, die eine Zoomlinse bilden. Die Linsenelemente 42 und die zugehörige Steuerschaltung (nicht gezeigt) sind so konfiguriert, dass die Elektronenenergie und die laterale Vergrößerung des Impulsverteilungsbildes in der reziproken Ebene RP3 veränderlich sind, um die Energie- und/oder Impulsauflösung der Energieanalysatorvorrichtung 200 zu optimieren. An beiden Enden der Zoomlinse aus den Linsenelementen 42 befinden sich Randelemente 41 und 43, die zur Bildung feldfreier Räume an den Enden der Zoomlinse angeordnet sind und einen Durchgriff von elektrischen Feldern auf den Bereich der Spaltblende 201 und den Eintritt der Energieanalysatorvorrichtung 200 in der dritten reziproken Ebene RP3 minimieren. Bei dieser Ausführungsform liegt in der Eintrittsebene der Energieanalysatorvorrichtung 200 ein Bild der Spaltblende 201, jedoch kein physischer Spalt, d. h. keine körperliche Spaltblende, vor.

Figur 4 zeigt eine bevorzugte Variante der dritten Ausführungsform der erfindungsgemäßen Elektronen-Abbildungsvorrichtung 100, wobei ebenfalls die dritte Linsengruppe 40 mit den Linsenelementen 42 und den Randelementen 41, 43 vorgesehen ist. Bei der dritten Ausführungsform ist jedoch die Spaltblende 201 in der dritten reziproken Ebene RP3 im Eintritt der Energieanalysatorvorrichtung 200 angeordnet. Auch in diesem Fall umfasst die dritte Linsengruppe 40 Linsenelemente 42, die eine Zoomlinse bilden, welche es erlaubt, die Elektronenenergie und die laterale Vergrößerung des Impulsverteilungsbildes in der dritten reziproken Ebene RP3 in weiten Bereichen zu verändern, um Energie- und Impulsauflösung der Energieanalysatorvorrichtung 200 zu optimieren. In diesem Fall kann ein konventioneller Energieanalysator mit integriertem Eintrittsspalt Verwendung finden.

In Figur 5 sind Varianten der Ablenkeinrichtung 20 gezeigt, welche bei verschiedenen Ausführungsformen vorgesehen sein können. So kann die Ablenkeinrichtung 20 gemäß Figur 5A mindestens zwei Elektroden 21 (als Parallelplatten-Ablenker bezeichnet) oder gemäß Figur 5B vier Elektroden 21 in einer Ebene (als x-y-Ablenker bezeichnet) oder gemäß Figur 5C acht Elektroden 21 in einer Ebene (als Oktupolanordnung oder Oktupol-Ablenker bezeichnet) umfassen. Die Ausführung gemäß Figur 5C ist besonders vorteilhaft, weil durch geeignete Spannungen an den acht Elektroden 21 die Ablenkung in jeder beliebigen Ebene durchgeführt werden kann, um so die Ablenkebene exakt entlang der x-Richtung, also exakt senkrecht zur Richtung des Eintrittsspaltes 201 auszurichten, wie in Figur 1B und 1C dargestellt ist. Ferner lassen sich durch die Oktupolanordnung unerwünschte Bilddrehungen durch möglicherweise auftretende longitudinale magnetische Streufelder beim Scanvorgang korrigieren.

Figur 6 zeigt schematisch eine Ausführungsform der Elektronen-Spektrometervorrichtung 300, umfassend die Elektronen-Abbildungsvorrichtung 100, z. B. gemäß einer der Figuren 1, 3 oder 4, und die Energieanalysatorvorrichtung 200 in Gestalt eines Halbkugelanalysators mit einem Elektronendetektor 202. Bei Ausführung des Elektronen-Spektrometrieverfahren werden die von der Probe 1 auf der Probenhalterung 101 emittierten Elektronen mit der Elektronen-Abbildungsvorrichtung 100 entlang der elektronenoptischen Achse OA zu der Energieanalysatorvorrichtung 200 übertragen. Die Aufnahme einer Energie- und Impulsverteilung der Elektronen erfolgt durch die Erfassung von Impulsverteilungsbildern der Elektronen entlang einer ersten Impulskoordinate entlang der Spaltblende 201 und durch die schrittweise Verschiebung des Impulsverteilungsbildes senkrecht zur Spaltblende 201, so dass die gesamte zweidimensionale Impulsverteilung aufgenommen werden kann.

Die in der vorstehenden Beschreibung, den Zeichnungen und den Ansprüchen offenbarten Merkmale der Erfindung können sowohl einzeln als auch in Kombination oder Unterkombination für die Verwirklichung der Erfindung in ihren verschiedenen Ausgestaltungen von Bedeutung sein.

### Bezugszeichenliste

- **100**: Elektronen-Abbildungsvorrichtung
- **101**: Probenhalter
- **200**: Energieanalysatorvorrichtung
- **201**: Spaltblende
- **202**: Elektronendetektor
- **300**: Elektronen-Spektrometervorrichtung
- **1**: Probe
- **2**: Elektronen
- **10**: erste Linsengruppe
- **11**: Frontkappen-Elektrode
- **12**: Fokuselektrode
- **13**: Anpassungslinse
- **20**: Ablenkeinrichtung
- **21**: Ablenkelement
- **22**: Driftstrecke
- **30**: zweite Linsengruppe
- **31**: Linsenelemente
- **32**: Randelement
- **40**: dritte Linsengruppe
- **41**: Randelement
- **42**: Zoomlinse
- **43**: Randelement
- **50**: Steuereinrichtung
- **RP1**: erste reziproke Ebene (Impulsbildebene)
- **GP1**: erste Gauß-Ebene (Ebene des Realraumbildes)
- **RP2**: zweite reziproke Ebene
- **GP2**: zweite Gauß-Ebene
- **RP3**: dritte reziproke Ebene
- **OA**: optische Achse
- **θ**: Emissionswinkel bzgl. OA
- **α**: Öffnungswinkel der Strahlenbündel
- **R**: Radius des Impulsverteilungsbildes
- **r**: Radius des Gaußbildes
- **x, y, z**: Richtungskoordinaten
- **kₓ, k_{y}, k_{z}**: Impulskoordinaten

## Patentansprüche

1. Elektronen-Abbildungsvorrichtung (100), die für einen Elektronentransfer entlang einer elektronenoptischen Achse (OA) von einer Elektronen (2) emittierenden Probe (1) zu einer Energieanalysatorvorrichtung (200) eingerichtet ist und eine probenseitige erste Linsengruppe (10), eine analysatorseitige zweite Linsengruppe (30) und eine Ablenkeinrichtung (20) umfasst, die zur Ablenkung der Elektronen (2) in einer Austrittsebene der Elektronen-Abbildungsvorrichtung (100) in einer Ablenkrichtung senkrecht zur elektronenoptischen Achse (OA) eingerichtet ist, wobei
- die erste Linsengruppe (10) eine erste reziproke Ebene (RP1) innerhalb der ersten Linsengruppe (10) und eine erste Gauß-Ebene (GP1) zwischen der ersten und der zweiten Linsengruppe (10, 30) bildet und zur Erzeugung eines ersten Impulsverteilungsbildes einer Impulsverteilung von Elektronen (2) aus der Probe (1) in der ersten reziproken Ebene (RP1) und zur Erzeugung eines ersten Gauß-Bildes der Probe (1) in der ersten Gauß-Ebene (GP1) eingerichtet ist,
- die zweite Linsengruppe (30) eine zweite reziproke Ebene (RP2) analysatorseitig von der zweiten Linsengruppe (30) bildet und zur Erzeugung eines zweiten Impulsverteilungsbildes der Impulsverteilung der Elektronen (2) aus der Probe (1) in der zweiten reziproken Ebene (RP2) eingerichtet ist,
**dadurch gekennzeichnet, dass**
- die erste Linsengruppe (10) zur Erzeugung des ersten Gauß-Bildes in einer vorderen Fokalebene der zweiten Linsengruppe (30) mit einer Ausdehnung senkrecht zur elektronenoptischen Achse (OA) geringer als 1 mm eingerichtet ist, so dass das mit der zweiten Linsengruppe (30) erzeugte zweite Impulsverteilungsbild ein Parallelbild ist, dessen Teilstrahlen beim Durchtritt durch die zweite reziproke Ebene (RP2) parallel zur elektronenoptischen Achse (OA) verlaufen oder eine Divergenz kleiner als 0,4° aufweisen, und
- die Ablenkeinrichtung (20) in der ersten Gauß-Ebene (GP1) oder in einer weiteren Gauß-Ebene (GP2) wirkt, so dass durch die Ablenkung der Elektronen (2) eine Parallelverschiebung der Teilstrahlen, welche in der zweiten reziproken Ebene (RP2) das Parallelbild bilden, ohne eine Veränderung der Winkel zwischen den Teilstrahlen senkrecht zur optischen Achse (OA) bewirkt wird.

2. Elektronen-Abbildungsvorrichtung gemäß Anspruch 1, bei der
- die Ablenkeinrichtung (20) so konfiguriert ist, dass die Ablenkeinrichtung (20) in einer einzigen Ebene senkrecht zur optischen Achse (OA) wirksam ist.

3. Elektronen-Abbildungsvorrichtung gemäß einem der vorhergehenden Ansprüche, bei der
- die Ablenkeinrichtung (20) ein einziges Paar von elektrisch und/oder magnetisch wirksamen Ablenkelementen (21), eine Quadrupolanordnung von vier Ablenkelementen (21) in einer Ebene oder eine Oktupolanordnung von acht Ablenkelementen (21) in einer Ebene umfasst.

4. Elektronen-Abbildungsvorrichtung gemäß einem der vorhergehenden Ansprüche, bei der
- die zweite reziproke Ebene (RP2) eine Austrittsebene der Elektronen-Abbildungsvorrichtung (100) ist, und
- in der zweiten reziproken Ebene (RP2) eine Spaltblende (201) angeordnet ist, welche einen Eintrittsspalt der Energieanalysatorvorrichtung (200) bildet.

5. Elektronen-Abbildungsvorrichtung gemäß einem der Ansprüche 1 bis 3, ferner umfassend
- mindestens eine dritte Linsengruppe (40), die analysatorseitig von der zweiten Linsengruppe (30) angeordnet ist und eine zweite Gauß-Ebene (GP2) innerhalb der mindestens einen dritten Linsengruppe (40) und analysatorseitig von der mindestens einen dritten Linsengruppe (40) eine dritte reziproke Ebene (RP3) bildet und zur Erzeugung eines zweiten Gauß-Bildes der Probe (1) in der zweiten Gauß-Ebene (GP2) und eines dritten Impulsverteilungsbildes der Impulsverteilung der Elektronen (2) aus der Probe (1) in der dritten reziproken Ebene (RP3) eingerichtet ist, wobei
- die dritte reziproke Ebene (RP3) die Austrittsebene der Elektronen-Abbildungsvorrichtung (100) ist, und
- das mit der mindestens einen dritten Linsengruppe (40) erzeugte dritte Impulsverteilungsbild ein Parallelbild ist.

6. Elektronen-Abbildungsvorrichtung gemäß Anspruch 5, bei der
- in der zweiten reziproken Ebene (RP2) eine Spaltblende (201) angeordnet ist, welche durch eine Abbildung in die Eintrittsebene der Energieanalysatorvorrichtung (200) einen Eintrittsspalt der Energieanalysatorvorrichtung (200) bildet, oder
- in der dritten reziproken Ebene (RP3) eine Spaltblende (201) angeordnet ist, welche einen Eintrittsspalt der Energieanalysatorvorrichtung (200) bildet, wobei in der zweiten reziproken Ebene (RP2) keine Spaltblende angeordnet ist.

7. Elektronen-Abbildungsvorrichtung gemäß einem der vorhergehenden Ansprüche, bei der
- die Ablenkeinrichtung (20) zwischen der ersten und der zweiten Linsengruppe (10, 30) und in der ersten Gauß-Ebene (GP1) angeordnet ist.

8. Elektronen-Abbildungsvorrichtung gemäß einem der Ansprüche 5 bis 6, bei der
- die Ablenkeinrichtung (20) an der dritten Linsengruppe (40) und in der zweiten Gauß-Ebene (GP2) angeordnet ist.

9. Elektronen-Abbildungsvorrichtung gemäß einem der vorhergehenden Ansprüche, mit mindestens einem der Merkmale
- die erste Linsengruppe (10) ist zur Erzeugung des ersten Gauß-Bildes mit einer Ausdehnung senkrecht zur elektronenoptischen Achse (OA) geringer als 0,5 mm eingerichtet,
- die erste und die zweite Linsengruppe (10, 30) sind eingerichtet, das Parallelbild mit Winkelabweichungen seiner Teilstrahlen kleiner als 0,2° zu bilden.

10. Elektronen-Abbildungsvorrichtung gemäß einem der vorhergehenden Ansprüche, mit mindestens einem der Merkmale
- das probenseitig vorderste elektronenoptische Element (11) der ersten Linsengruppe (10) ist eingerichtet, das gleiche Potential wie die Probe (1) aufzuweisen, um so einen feldfreien Bereich vor der Probe zu erzeugen, und
- die Ablenkeinrichtung (20) ist mit einer Steuereinrichtung (50) gekoppelt, die für eine scannende Ablenkung der Elektronen (2) in der Austrittsebene der Elektronen-Abbildungsvorrichtung unter Beibehaltung des Parallelbildes eingerichtet ist.

11. Elektronen-Spektrometervorrichtung (300), umfassend
- eine Probenhalterung (101), die zur Halterung einer Probe (1) eingerichtet ist,
- eine Elektronen-Abbildungsvorrichtung (100) gemäß einem der vorhergehenden Ansprüche, und
- eine Energieanalysatorvorrichtung (200), wobei
- die Elektronen-Abbildungsvorrichtung (100) für den Elektronentransfer von Elektronen, die von der Probe (1) emittiert werden, entlang der elektronenoptischen Achse (OA) zu der Energieanalysatorvorrichtung (200) angeordnet ist.

12. Elektronen-Spektrometervorrichtung gemäß Anspruch 11, bei der
- die Energieanalysatorvorrichtung (200) einen Halbkugelanalysator umfasst.

13. Elektronentransferverfahren, bei dem mit einer Elektronen-Abbildungsvorrichtung Elektronen (2) von einer Probe (1) entlang einer elektronenoptischen Achse (OA) zu einer Energieanalysatorvorrichtung (200) übertragen werden, wobei die Elektronen (2) aufeinander folgend durch eine probenseitige erste Linsengruppe (10) und eine analysatorseitige zweite Linsengruppe (30) hindurchtreten und die Elektronen (2) mit einer Ablenkeinrichtung (20) in einer Austrittsebene der Elektronen-Abbildungsvorrichtung (100) in einer Ablenkrichtung senkrecht zur elektronenoptischen Achse (OA) abgelenkt werden, wobei
- die erste Linsengruppe (10) eine erste reziproke Ebene (RP1) innerhalb der ersten Linsengruppe (10) und eine erste Gauß-Ebene (GP1) zwischen der ersten und der zweiten Linsengruppe (30) bildet und ein erstes Impulsverteilungsbild einer Impulsverteilung von Elektronen (2) aus der Probe (1) in der ersten reziproken Ebene (RP1) und eines erstes Gauß-Bildes der Probe (1) in der ersten Gauß-Ebene (GP1) erzeugt,
- die zweite Linsengruppe (30) eine zweite reziproke Ebene (RP2) analysatorseitig von der zweiten Linsengruppe bildet und ein zweites Impulsverteilungsbild der Impulsverteilung der Elektronen (2) aus der Probe (1) in der zweiten reziproken Ebene (RP2) erzeugt,
**dadurch gekennzeichnet, dass**
- die erste Linsengruppe (10) das erste Gauß-Bild in einer vorderen Fokalebene der zweiten Linsengruppe (30) mit einer Ausdehnung senkrecht zur elektronenoptischen Achse (OA) geringer als 1 mm erzeugt, so dass das mit der zweiten Linsengruppe (30) erzeugte zweite Impulsverteilungsbild ein Parallelbild ist, dessen Teilstrahlen beim Durchtritt durch die zweite reziproke Ebene (RP2) parallel zur elektronenoptischen Achse (OA) verlaufen oder eine Divergenz kleiner als 0,4° aufweisen, und
- die Ablenkeinrichtung (20) in der ersten Gauß-Ebene (GP1) oder in einer weiteren Gauß-Ebene (GP2) wirkt, so dass durch die Ablenkung der Elektronen (2) eine Parallelverschiebung der Teilstrahlen, welche in der zweiten reziproken Ebene (RP2) das Parallelbild bilden, ohne eine Veränderung der Winkel zwischen den Teilstrahlen senkrecht zur optischen Achse (OA) bewirkt wird.

14. Elektronentransferverfahren gemäß Anspruch 13, bei dem
- die Ablenkeinrichtung (20) so konfiguriert ist, dass die Ablenkeinrichtung (20) in einer einzigen Ebene senkrecht zur optischen Achse (OA) wirksam ist.

15. Elektronentransferverfahren gemäß einem der Ansprüche 13 bis 14, bei der
- die zweite reziproke Ebene die Austrittsebene der Elektronen-Abbildungsvorrichtung ist, und
- in der zweiten reziproken Ebene eine Spaltblende (201) angeordnet ist, welche einen Eintrittsspalt der Energieanalysatorvorrichtung (200) bildet.

16. Elektronentransferverfahren gemäß einem der Ansprüche 13 bis 14, wobei
- mit mindestens einer dritten Linsengruppe (40), die analysatorseitig von der zweiten Linsengruppe (30) angeordnet ist, eine zweite Gauß-Ebene (GP2) innerhalb der mindestens einen dritten Linsengruppe (40) und analysatorseitig von der mindestens einen dritten Linsengruppe (40) eine dritte reziproke Ebene (RP3) gebildet wird und ein zweites Gauß-Bild der Probe (1) in der zweiten Gauß-Ebene (GP2) und ein drittes Impulsverteilungsbild der Elektronen (2) aus der Probe (1) in der dritten reziproken Ebene (RP3) erzeugt werden, wobei
- die dritte reziproke Ebene (RP3) die Austrittsebene der Elektronen-Abbildungsvorrichtung (100) ist, und
- das mit der mindestens einen dritten Linsengruppe (40) erzeugte dritte Impulsverteilungsbild ein Parallelbild ist.

17. Elektronentransferverfahren gemäß Anspruch 16, bei dem
- in der zweiten reziproken Ebene (RP2) eine Spaltblende (201) angeordnet ist, welche durch eine Abbildung in die Eintrittsebene der Energieanalysatorvorrichtung (200) einen Eintrittsspalt der Energieanalysatorvorrichtung (200) in Form des Bildes der Spaltblende (201) bildet, oder
- in der dritten reziproken Ebene (RP3) eine Spaltblende (201) angeordnet ist, welche einen Eintrittsspalt der Energieanalysatorvorrichtung (200) bildet, wobei in der zweiten reziproken Ebene (RP2) keine Spaltblende angeordnet ist.

18. Elektronentransferverfahren gemäß einem der Ansprüche 13 bis 17, bei dem
- die Ablenkeinrichtung (20) in der ersten Gauß-Ebene (GP1) angeordnet ist.

19. Elektronen-Abbildungsvorrichtung gemäß einem der Ansprüche 16 bis 17, bei der
- die Ablenkeinrichtung (20) an der mindestens einen dritten Linsengruppe (40) und in der zweiten Gauß-Ebene (GP2) angeordnet ist.

20. Elektronentransferverfahren gemäß einem der Ansprüche 13 bis 19, mit mindestens einem der Merkmale
- die erste Linsengruppe (10) erzeugt das erste Gauß-Bild mit einer Ausdehnung senkrecht zur elektronenoptischen Achse (OA) geringer als 0,5 mm,
- die erste und zweite Linsengruppe (30) sind eingerichtet, das Parallelbild mit Winkelabweichungen seiner Teilstrahlen kleiner als 0,2° zu bilden,
- das probenseitig vorderste elektronenoptische Element der ersten Linsengruppe (10) weist das gleiche Potential wie die Probe (1) auf, um im Bereich der Probe einen feldfreien Bereich zu erzeugen, und
- die Elektronen (2) in der Austrittsebene der Elektronen-Abbildungsvorrichtung (100) werden zur Erzeugung einer Scan-Bewegung des Impulsverteilungsbildes unter Beibehaltung des Parallelbildes abgelenkt.

21. Elektronen-Spektrometrieverfahren, umfassend die Schritte
- Bestrahlung einer Probe (1) und Emission von Elektronen (2) von der Probe (1),
- Übertragung der emittierten Elektronen (2) mit einem Elektronentransferverfahren gemäß einem der Ansprüche 13 bis 20 zu einer Energieanalysatorvorrichtung (200), und
- energieaufgelöste Detektion der Elektronen (2) mit der Energieanalysatorvorrichtung (200).

22. Elektronen-Spektrometrieverfahren gemäß Anspruch 21, bei dem
- die Energieanalysatorvorrichtung (200) einen Halbkugelanalysator umfasst.

## Claims

1. An electron imaging apparatus (100) that is configured for an electron transfer along an electron-optical axis (OA) from a sample (1) emitting electrons (2) to an energy analyzer apparatus (200) and comprises a first lens group (10) on a sample side and a second lens group (30) on an analyzer side and a deflector device (20) that is configured to deflect the electrons (2) in an exit plane of the electron imaging apparatus (100) in a deflection direction perpendicular to the electron-optical axis (OA), wherein:
- the first lens group (10) provides a first reciprocal plane (RP1) inside the first lens group (10) and a first Gaussian plane (GP1) between the first and the second lens group (10, 30) and is configured to generate a first momentum distribution image of a momentum distribution of electrons (2) from the sample (1) in the first reciprocal plane (RP1) and to generate a first Gaussian image of the sample (1) in the first Gaussian plane (GP1),
- the second lens group (30) provides a second reciprocal plane (RP2) on the analyzer side of the second lens group (30) and is configured to generate a second momentum distribution image of the momentum distribution of the electrons (2) from the sample (1) in the second reciprocal plane (RP2),
**characterized in that**
- the first lens group (10) is configured to generate the first Gaussian image in a front focal plane of the second lens group (30) with an extent perpendicular to the electron-optical axis (OA) of less than 1 mm, so that the second momentum distribution image generated by the second lens group (30) is a parallel image, the partial beams of which run parallel to the electron-optical axis (OA) on passing through the second reciprocal plane (RP2) or have a divergence smaller than 0.4°, and
- the deflector device (20) acts in the first Gaussian plane (GP1) or in another Gaussian plane (GP2), so that the deflection of the electrons (2) effects a parallel displacement of the partial beams, which form the parallel image in the second reciprocal plane (RP2), without changing the angle between the partial beams perpendicular to the optical axis (OA).

2. The electron imaging apparatus according to claim 1, wherein the deflector device (20) is configured such that the deflector device (20) acts in one single plane perpendicular to the optical axis (OA).

3. The electron imaging apparatus according to any of the previous claims, wherein
- the deflector device (20) comprises one single pair of electrically and/or magnetically acting deflector elements (21), a quadrupole arrangement of four deflector elements (21) in one plane or an octupole arrangement of eight deflector elements (21) in one plane.

4. The electron imaging apparatus according to any of the previous claims, wherein:
- the second reciprocal plane (RP2) is an exit plane of the electron imaging apparatus (100), and
- a slit diaphragm (201) is arranged in the second reciprocal plane (RP2), forming an entry slit of the energy analyzer apparatus (200).

5. The electron imaging apparatus according to any of the claims 1 to 3, further comprising:
- at least one third lens group (40), that is arranged on the analyzer side of the second lens group (30) and forms a second Gaussian plane (GP2) inside the at least one third lens group (40) and a third reciprocal plane (RP3) on the analyzer side of the at least one third lens group (40) and is configured to generate a second Gaussian image of the sample (1) in the second Gaussian plane (GP2) and a third momentum distribution image of the momentum distribution of the electrons (2) from the sample (1) in the third reciprocal plane (RP3), wherein
- the third reciprocal plane (RP3) is the exit plane of the electron imaging apparatus (100), and
- the third momentum distribution image generated by the at least one third lens group (40) is a parallel image.

6. The electron imaging apparatus according to claim 5, wherein
- a slit diaphragm (201) is arranged in the second reciprocal plane (RP2), said slit diaphragm forming an entry slit of the energy analyzer apparatus (200) by imaging into the entry plane of the energy analyzer apparatus (200), or
- a slit diaphragm (201) is arranged in the third reciprocal plane (RP3), forming an entry slit of the energy analyzer apparatus (200), wherein no slit diaphragm is arranged in the second reciprocal plane (RP2).

7. The electron imaging apparatus according to any of the previous claims, wherein
- the deflector device (20) is arranged between the first and the second lens group (10, 30) and in the first Gaussian plane (GP1).

8. The electron imaging apparatus according to claim 5 or 6, wherein
- the deflector device (20) is arranged at the third lens group (40) and in the second Gaussian plane (GP2).

9. The electron imaging apparatus according to any of the previous claims, having at least one of the features
- the first lens group (10) is configured to generate the first Gaussian image with an extent perpendicular to the electron-optical axis (OA) of less than 0.5 mm,
- the first and the second lens group (10, 30) are configured to form the parallel image with angular deviations of its partial beams of less than 0.2°.

10. The electron imaging apparatus according to any of the previous claims, having at least one of the features
- a foremost sample-side electron-optical element (11) of the first lens group (10) is configured to have a same potential as the sample (1), so as to generate a field-free area in front of the sample, and
- the deflector device (20) is coupled to a control device (50), which is configured for a scanning deflection of the electrons (2) in the exit plane of the electron imaging apparatus while preserving the parallel image.

11. An electron spectrometer apparatus (300), comprising:
- a sample-holder (101) configured to hold a sample (1),
- an electron imaging apparatus (100) according to any of the previous claims, and
- an energy analyzer apparatus (200), wherein
- the electron imaging apparatus (100) is configured for electron transfer of electrons emitted from the sample (1) along the electron-optical axis (OA) to the energy analyzer apparatus (200).

12. The electron spectrometer apparatus according to claim 11, wherein
- the energy analyzer apparatus (200) comprises a hemispherical analyzer.

13. An electron transfer method, wherein electrons (2) from a sample (1) are transferred by an electron imaging apparatus along an electron-optical axis (OA) to an energy analyzer apparatus (200), wherein the electrons (2) pass in sequence through a sample-side first lens group (10) and an analyzer-side second lens group (30) and the electrons (2) are deflected by a deflector device (20) in an exit plane of the electron imaging apparatus (100) in a deflection direction perpendicular to the electron-optical axis (OA), wherein:
- the first lens group (10) forms a first reciprocal plane (RP1) inside the first lens group (10) and a first Gaussian plane (GP1) between the first and the second lens group (30) and generates a first momentum distribution image of a momentum distribution of electrons (2) from the sample (1) in the first reciprocal plane (RP1) and a first Gaussian image of the sample (1) in the first Gaussian plane (GP1),
- the second lens group (30) forms a second reciprocal plane (RP2) on the analyzer side of the second lens group and generates a second momentum distribution image of the momentum distribution of the electrons (2) from the sample (1) in the second reciprocal plane (RP2),
**characterized in that**
- the first lens group (10) generates the first Gaussian image in a front focal plane of the second lens group (30) with an extent perpendicular to the electron-optical axis (OA) of less than 1 mm, so that the second momentum distribution image generated by the second lens group (30) is a parallel image, the partial beams of which run parallel to the electron-optical axis (OA) on passing through the second reciprocal plane (RP2) or have a divergence smaller than 0.4°, and
- the deflector device (20) acts in the first Gaussian plane (GP1) or in another Gaussian plane (GP2), so that the deflection of the electrons (2) effects a parallel displacement of the partial beams, which form the parallel image in the second reciprocal plane (RP2), without changing the angle between the partial beams perpendicular to the optical axis (OA).

14. The electron transfer method according to claim 13, wherein
- the deflector device (20) is configured such that the deflector device (20) acts in one single plane perpendicular to the optical axis (OA).

15. The electron transfer method according to claim 13 or 14, wherein:
- the second reciprocal plane is the exit plane of the electron imaging apparatus, and
- a slit diaphragm (201) that forms an entrance slit of the energy analyzer apparatus (200) is arranged in the second reciprocal plane.

16. The electron transfer method according to claim 13 or 14, wherein
- at least one third lens group (40) that is arranged on the analyzer side of the second lens group (30) forms a second Gaussian plane (GP2) inside the at least one third lens group (40) and a third reciprocal plane (RP3) on the analyzer side of the at least one third lens group (40) and generates a second Gaussian image of the sample (1) in the second Gaussian plane (GP2) and a third momentum distribution image of the electrons (2) from the sample (1) in the third reciprocal plane (RP3), wherein:
- the third reciprocal plane (RP3) is the exit plane of the electron imaging apparatus (100), and
- the third momentum distribution image generated by the at least one third lens group (40) is a parallel image.

17. The electron transfer method according to claim 16, wherein
- a slit diaphragm (201) is arranged in the second reciprocal plane (RP2), said slit diaphragm (201) forming an entry slit of the energy analyzer apparatus (200) in form of the image of the slit diaphragm (201) by imaging into the entry plane of the energy analyzer apparatus (200), or
- a slit diaphragm (201) is arranged in the third reciprocal plane (RP3), forming an entry slit of the energy analyzer apparatus (200), wherein no slit diaphragm is arranged in the second reciprocal plane (RP2).

18. The electron transfer method according to any of the claims 13 to 17, wherein
- the deflector device (20) is arranged in the first Gaussian plane (GP1).

19. The electron imaging apparatus according to claim 16 or 17, wherein
- the deflector device (20) is arranged at the at least one third lens group (40) and in the second Gaussian plane (GP2).

20. The electron transfer method according to any of the claims 13 to 19, having at least one of the features
- the first lens group (10) generates the first Gaussian image with an extent perpendicular to the electron-optical axis (OA) of less than 0.5 mm,
- the first and the second lens group (30) are configured to form the parallel image with angular deviations of its partial beams of less than 0.2°,
- a foremost sample-side electron-optical element of the first lens group (10) has the same potential as the sample (1), so as to generate a field-free area in the region of the sample, and
- the electrons (2) in the exit plane of the electron imaging apparatus (100) are deflected to generate a scanning motion of the momentum distribution image while preserving the parallel image.

21. An electron spectroscopy method, comprising the steps:
- irradiation of a sample (1) and emission of electrons (2) from the sample (1),
- transfer of the electrons (2) emitted from the sample by an electron transfer method according to any of the claims 13 to 20 to an energy analyzer apparatus (200), and
- energy-resolved detection of the electrons (2) by the energy analyzer apparatus (200).

22. The electron spectrometry method according to claim 21, wherein
- the energy analyzer apparatus (200) comprises a hemispherical analyzer.

## Revendications

1. Dispositif d'imagerie d'électrons (100), lequel est conçu pour un transfert d'électrons le long d'un axe optoélectronique (OA) depuis un échantillon (1) émettant des électrons (2) vers un dispositif analyseur d'énergie (200) et comprend un premier groupe de lentilles (10) côté échantillon, un deuxième groupe de lentilles (30) côté analyseur et un appareil de déviation (20) qui est configuré pour la déviation des électrons (2) dans un plan de sortie du dispositif d'imagerie d'électrons (100) dans un sens de déviation perpendiculaire à l'axe optoélectronique (OA),
- le premier groupe de lentilles (10) formant un premier plan réciproque (RP1) à l'intérieur du premier groupe de lentilles (10) et un premier plan de Gauss (GP1) entre le premier et le deuxième groupe de lentilles (10, 30) et étant configuré pour la génération d'une première image de distribution d'impulsion d'une distribution d'impulsion d'électrons (2) provenant de l'échantillon (1) dans le premier plan réciproque (RP1) et pour la génération d'une première image gaussienne de l'échantillon (1) dans le premier plan de Gauss (GP1),
- le deuxième groupe de lentilles (30) formant un deuxième plan réciproque (RP2) côté analyseur du deuxième groupe de lentilles (30) et étant configuré pour la génération d'une deuxième image de distribution d'impulsion de la distribution d'impulsion des électrons (2) provenant de l'échantillon (1) dans le deuxième plan réciproque (RP2), **caractérisé en ce que**
- le premier groupe de lentilles (10) est configuré pour la génération de la première image gaussienne dans un plan focal avant du deuxième groupe de lentilles (30) avec une extension perpendiculairement à l'axe optoélectronique (OA) inférieure à 1 mm, de sorte que la deuxième image de distribution d'impulsion générée par le deuxième groupe de lentilles (30) est une image parallèle dont les faisceaux partiels s'étendent, lors du passage à travers le deuxième plan réciproque (RP2), parallèlement à l'axe optoélectronique (OA) ou présentent une divergence inférieure à 0,4°, et
- l'appareil de déviation (20) agit dans le premier plan de Gauss (GP1) ou dans un autre plan de Gauss (GP2), de sorte que la déviation des électrons (2) entraîne un décalage parallèle des faisceaux partiels, lesquels forment l'image parallèle dans le deuxième plan réciproque (RP2), sans modification de l'angle entre les faisceaux partiels perpendiculairement à l'axe optique (OA).

2. Dispositif d'imagerie d'électrons selon la revendication 1, dans lequel
- l'appareil de déviation (20) est configuré de sorte que l'appareil de déviation (20) est actif dans un seul plan perpendiculaire à l'axe optique (OA).

3. Dispositif d'imagerie d'électrons selon l'une des revendications précédentes, dans lequel
- l'appareil de déviation (20) comprend une seule paire d'éléments de déviation (21) actifs électriquement et/ou magnétiquement, une disposition quadripolaire de quatre éléments de déviation (21) dans un plan ou une disposition octopolaire de huit éléments de déviation (21) dans un plan.

4. Dispositif d'imagerie d'électrons selon l'une des revendications précédentes, dans lequel
- le deuxième plan réciproque (RP2) est un plan de sortie du dispositif d'imagerie d'électrons (100), et
- un diaphragme à fente (201) est disposé dans le deuxième plan réciproque (RP2), lequel diaphragme à fente forme une fente d'entrée du dispositif analyseur d'énergie (200).

5. Dispositif d'imagerie d'électrons selon l'une des revendications 1 à 3, comprenant en outre
- au moins un troisième groupe de lentilles (40) qui est disposé côté analyseur du deuxième groupe de lentilles (30) et forme un second plan de Gauss (GP2) à l'intérieur de l'au moins un troisième groupe de lentilles (40) et un troisième plan réciproque (RP3) côté analyseur de l'au moins un troisième groupe de lentilles (40) et qui est configuré pour la génération d'une seconde image gaussienne de l'échantillon (1) dans le second plan de Gauss (GP2) et d'une troisième image de distribution d'impulsion de la distribution d'impulsion des électrons (2) provenant de l'échantillon (1) dans le troisième plan réciproque (RP3),
- le troisième plan réciproque (RP3) étant le plan de sortie du dispositif d'imagerie d'électrons (100), et
- la troisième image de distribution d'impulsion générée par l'au moins un troisième groupe de lentilles (40) étant une image parallèle.

6. Dispositif d'imagerie d'électrons selon la revendication 5, dans lequel
- un diaphragme à fente (201) est disposé dans le deuxième plan réciproque (RP2), lequel diaphragme à fente forme, par une imagerie dans le plan d'entrée du dispositif analyseur d'énergie (200), une fente d'entrée du dispositif analyseur d'énergie (200), ou
- un diaphragme à fente (201) est disposé dans le troisième plan réciproque (RP3), lequel diaphragme à fente forme une fente d'entrée du dispositif analyseur d'énergie (200), aucun diaphragme à fente n'étant disposé dans le deuxième plan réciproque (RP2).

7. Dispositif d'imagerie d'électrons selon l'une des revendications précédentes, dans lequel
- l'appareil de déviation (20) est disposé entre le premier et le deuxième groupe de lentilles (10, 30) et dans le premier plan de Gauss (GP1).

8. Dispositif d'imagerie d'électrons selon l'une des revendications 5 à 6, dans lequel
- l'appareil de déviation (20) est disposé au niveau du troisième groupe de lentilles (40) et dans le second plan de Gauss (GP2).

9. Dispositif d'imagerie d'électrons selon l'une des revendications précédentes, comportant au moins l'une des caractéristiques suivantes
- le premier groupe de lentilles (10) est configuré pour la génération de la première image gaussienne avec une extension perpendiculairement à l'axe optoélectronique (OA) inférieure à 0,5 mm,
- le premier et le deuxième groupe de lentilles (10, 30) sont configurés pour former l'image parallèle avec des écarts angulaires de ses faisceaux partiels inférieurs à 0,2°.

10. Dispositif d'imagerie d'électrons selon l'une des revendications précédentes, comportant au moins l'une des caractéristiques suivantes
- l'élément optoélectronique (11) le plus en avant côté échantillon du premier groupe de lentilles (10) est configuré pour présenter le même potentiel que l'échantillon (1) afin de générer une zone sans champ devant l'échantillon, et
- l'appareil de déviation (20) est couplé à un appareil de commande (50) qui est configuré pour une déviation de balayage des électrons (2) dans le plan de sortie du dispositif d'imagerie d'électrons en maintenant l'image parallèle.

11. Dispositif spectromètre d'électrons (300), comprenant
- un support d'échantillon (101) qui est conçu pour le support d'un échantillon (1),
- un dispositif d'imagerie d'électrons (100) selon l'une des revendications précédentes, et
- un dispositif analyseur d'énergie (200),
- le dispositif d'imagerie d'électrons (100) étant disposé le long de l'axe optoélectronique (OA) vers le dispositif analyseur d'énergie (200) pour le transfert d'électrons d'électrons qui sont émis en provenance de l'échantillon (1).

12. Dispositif spectromètre d'électrons selon la revendication 11, dans lequel
- le dispositif analyseur d'énergie (200) comprend un analyseur hémisphérique.

13. Procédé de transfert d'électrons, dans lequel, au moyen d'un dispositif d'imagerie d'électrons, des électrons (2) sont transmis depuis un échantillon (1) le long d'un axe optoélectronique (OA) vers un dispositif analyseur d'énergie (200), les électrons (2) traversant successivement un premier groupe de lentilles (10) côté échantillon et un deuxième groupe de lentilles (30) côté analyseur et les électrons (2) étant déviés au moyen d'un appareil de déviation (20) dans un plan de sortie du dispositif d'imagerie d'électrons (100) dans un sens de déviation perpendiculaire à l'axe optoélectronique (OA),
- le premier groupe de lentilles (10) formant un premier plan réciproque (RP1) à l'intérieur du premier groupe de lentilles (10) et un premier plan de Gauss (GP1) entre le premier et le deuxième groupe de lentilles (30) et générant une première image de distribution d'impulsion d'une distribution d'impulsion d'électrons (2) provenant de l'échantillon (1) dans le premier plan réciproque (RP1) et une première image gaussienne de l'échantillon (1) dans le premier plan de Gauss (GP1),
- le deuxième groupe de lentilles (30) formant un deuxième plan réciproque (RP2) côté analyseur du deuxième groupe de lentilles et générant une deuxième image de distribution d'impulsion de la distribution d'impulsion des électrons (2) provenant de l'échantillon (1) dans le deuxième plan réciproque (RP2),
**caractérisé en ce que**
- le premier groupe de lentilles (10) génère la première image gaussienne dans un plan focal avant du deuxième groupe de lentilles (30) avec une extension perpendiculairement à l'axe optoélectronique (OA) inférieure à 1 mm, de sorte que la deuxième image de distribution d'impulsion générée par le deuxième groupe de lentilles (30) est une image parallèle dont les faisceaux partiels s'étendent, lors du passage à travers le deuxième plan réciproque (RP2), parallèlement à l'axe optoélectronique (OA) ou présentent une divergence inférieure à 0,4°, et
- l'appareil de déviation (20) agit dans le premier plan de Gauss (GP1) ou dans un autre plan de Gauss (GP2), de sorte que la déviation des électrons (2) entraîne un décalage parallèle des faisceaux partiels, lesquels forment l'image parallèle dans le deuxième plan réciproque (RP2), sans modification de l'angle entre les faisceaux partiels perpendiculairement à l'axe optique (OA).

14. Procédé de transfert d'électrons selon la revendication 13, dans lequel
- l'appareil de déviation (20) est configuré de sorte que l'appareil de déviation (20) est actif dans un seul plan perpendiculaire à l'axe optique (OA).

15. Procédé de transfert d'électrons selon l'une des revendications 13 à 14, dans lequel
- le deuxième plan réciproque est le plan de sortie du dispositif d'imagerie d'électrons, et
- un diaphragme à fente (201) est disposé dans le deuxième plan réciproque, lequel diaphragme à fente forme une fente d'entrée du dispositif analyseur d'énergie (200).

16. Procédé de transfert d'électrons selon l'une des revendications 13 à 14,
- à l'aide d'au moins un troisième groupe de lentilles (40) qui est disposé côté analyseur du deuxième groupe de lentilles (30), un second plan de Gauss (GP2) étant formé à l'intérieur de l'au moins un troisième groupe de lentilles (40) et un troisième plan réciproque (RP3) étant formé côté analyseur de l'au moins un troisième groupe de lentilles (40) et une seconde image gaussienne de l'échantillon (1) étant générée dans le second plan de Gauss (GP2) et une troisième image de distribution d'impulsion des électrons (2) provenant de l'échantillon (1) étant générée dans le troisième plan réciproque (RP3),
- le troisième plan réciproque (RP3) étant le plan de sortie du dispositif d'imagerie d'électrons (100), et
- la troisième image de distribution d'impulsion générée par l'au moins un troisième groupe de lentilles (40) étant une image parallèle.

17. Procédé de transfert d'électrons selon la revendication 16, dans lequel
- un diaphragme à fente (201) est disposé dans le deuxième plan réciproque (RP2), lequel diaphragme à fente forme, par une imagerie dans le plan d'entrée du dispositif analyseur d'énergie (200), une fente d'entrée du dispositif analyseur d'énergie (200) sous la forme de l'image du diaphragme à fente (201), ou
- un diaphragme à fente (201) est disposé dans le troisième plan réciproque (RP3), lequel diaphragme à fente forme une fente d'entrée du dispositif analyseur d'énergie (200), aucun diaphragme à fente n'étant disposé dans le deuxième plan réciproque (RP2).

18. Procédé de transfert d'électrons selon l'une des revendications 13 à 17, dans lequel
- l'appareil de déviation (20) est disposé dans le premier plan de Gauss (GP1).

19. Dispositif d'imagerie d'électrons selon l'une des revendications 16 à 17, dans lequel
- l'appareil de déviation (20) est disposé au niveau de l'au moins un troisième groupe de lentilles (40) et dans le second plan de Gauss (GP2).

20. Procédé de transfert d'électrons selon l'une des revendications 13 à 19, comportant au moins l'une des caractéristiques suivantes
- le premier groupe de lentilles (10) génère la première image gaussienne avec une extension perpendiculairement à l'axe optoélectronique (OA) inférieure à 0,5 mm,
- le premier et le deuxième groupe de lentilles (30) sont configurés pour former l'image parallèle avec des écarts angulaires de ses faisceaux partiels inférieurs à 0,2°,
- l'élément optoélectronique le plus en avant côté échantillon du premier groupe de lentilles (10) présente le même potentiel que l'échantillon (1) afin de générer une zone sans champ dans la zone de l'échantillon, et
- les électrons (2) sont déviés dans le plan de sortie du dispositif d'imagerie d'électrons (100) pour la génération d'un mouvement de balayage de l'image de distribution d'impulsion en maintenant l'image parallèle.

21. Procédé de spectrométrie d'électrons, comprenant les étapes
- d'irradiation d'un échantillon (1) et d'émission d'électrons (2) provenant de l'échantillon (1),
- de transmission des électrons (2) émis au moyen d'un procédé de transfert d'électrons selon l'une des revendications 13 à 20 à un dispositif analyseur d'énergie (200), et
- de détection résolue en énergie des électrons (2) au moyen du dispositif analyseur d'énergie (200).

22. Procédé de spectrométrie d'électrons selon la revendication 21, dans lequel
- le dispositif analyseur d'énergie (200) comprend un analyseur hémisphérique.
